# EUROPEAN PATENT SPECIFICATION

(11) **EP 4 333 040 B1**
(45) Date of publication and mention of the grant of the patent: **11.06.2025**
(21) Application number: 23181554.9
(22) Date of filing: 26.06.2023
(51) Int. Cl.: H10D 84/01, H10D 84/83, H10D 30/43, H10D 84/85, H10D 64/23, H10D 30/67

(54) **SEMICONDUCTOR DEVICE**
HALBLEITERANORDNUNG
DISPOSITIF SEMI-CONDUCTEUR

(30) Priority: 12.08.2022 KR 20220101137
(43) Date of publication of application: 06.03.2024
(73) Proprietor: Samsung Electronics Co., Ltd., Suwon-si, Gyeonggi-do 16677 (KR)
(72) Inventor: KIM, Jin, Suwon-si, 16677 (KR); KIM, Namjae, Suwon-si, 16677 (KR); KIM, Subin, Suwon-si, 16677 (KR); KIM, Byungmoo, Suwon-si, 16677 (KR); JEON, Joongwon, Suwon-si, 16677 (KR)
(74) Representative: Marks & Clerk LLP

(56) References cited:
- DE-A1- 102018 121 263
- JP-A- 2021 061 278
- US-A1- 2011 147 765
- US-A1- 2015 380 405
- US-A1- 2016 049 395
- US-A1- 2019 109 193
- US-A1- 2019 198 499
- US-A1- 2019 393 206
- US-A1- 2020 006 484

## Description

### 1. Technical Field

Embodiments of the inventive concept relate to a semiconductor device. Particularly, embodiments of the inventive concept relate to a semiconductor device including a p-channel metal-oxide-semiconductor (PMOS) field effect transistor (FET).

### 2. Description of the Related Art

A semiconductor device is an electronic device that may include field effect transistors (FETs). When configuring circuits using FETs, wirings for electrically connecting to a FET may be formed on the FET. An impurity region for power supply, also referred to as a "tap region", may be formed on a substrate on which the semiconductor device is formed. An impurity region serving as a source/drain of a p-channel metal-oxide-semiconductor (PMOS) FET may be electrically connected to an n-well tap region.

US 2020/006484 A1 discloses a method that includes receiving a semiconductor substrate that includes an integrated circuit cell and a well tap rape surrounding the integrated circuit cell.

### SUMMARY

Example embodiments of the inventive concept provide a semiconductor device including a p-channel metal-oxide-semiconductor (PMOS) field effect transistor (FET), as defined in the appended claims.

### BRIEF DESCRIPTION OF THE DRAWINGS

Example embodiments of the inventive concept will be more clearly understood from the following detailed description taken in conjunction with the accompanying drawings. FIGS. 1 to 30 represent non-limiting, example embodiments of the inventive concept as described herein.
FIG. 1 is a plan view of a semiconductor device in accordance with example embodiments of the inventive concept;
FIG. 2 is a cross-sectional view of a semiconductor device in accordance with example embodiments of the inventive concept;
FIG. 3 is a cross-sectional view of a semiconductor device in accordance with example embodiments of the inventive concept;
FIG. 4 is a cross-sectional view of a semiconductor device in accordance with example embodiments of the inventive concept;
FIG. 5 is a plan view of a semiconductor device in accordance with example embodiments of the inventive concept;
FIG. 6 is a cross-sectional view of a semiconductor device in accordance with example embodiments of the inventive concept;
FIG. 7 is a plan view of a semiconductor device in accordance with example embodiments of the inventive concept;
FIG 8 is a cross-sectional view of a semiconductor device in accordance with example embodiments of the inventive concept;
FIG 9 is a plan view of a semiconductor device in accordance with example embodiments of the inventive concept;
FIG 10 is a cross-sectional view of a semiconductor device in accordance with example embodiments of the inventive concept;
FIGS. 11, 12, 13, 14, 15, 16, 17, 18, 19, 20, 21, 22, 23, 24, 25, 26, 27 and 28 are cross-sectional views and plan views illustrating a method of manufacturing a semiconductor device in accordance with example embodiments of the inventive concept;
FIG 29 is a plan view illustrating a method of manufacturing a semiconductor device in accordance with example embodiments of the inventive concept; and
FIG 30 is a plan view illustrating a method of manufacturing a semiconductor device in accordance with example embodiments of the inventive concept.

### DETAILED DESCRIPTION OF THE EMBODIMENTS

Hereinafter, example embodiments of the inventive concept will be described in detail with reference to the accompanying drawings.

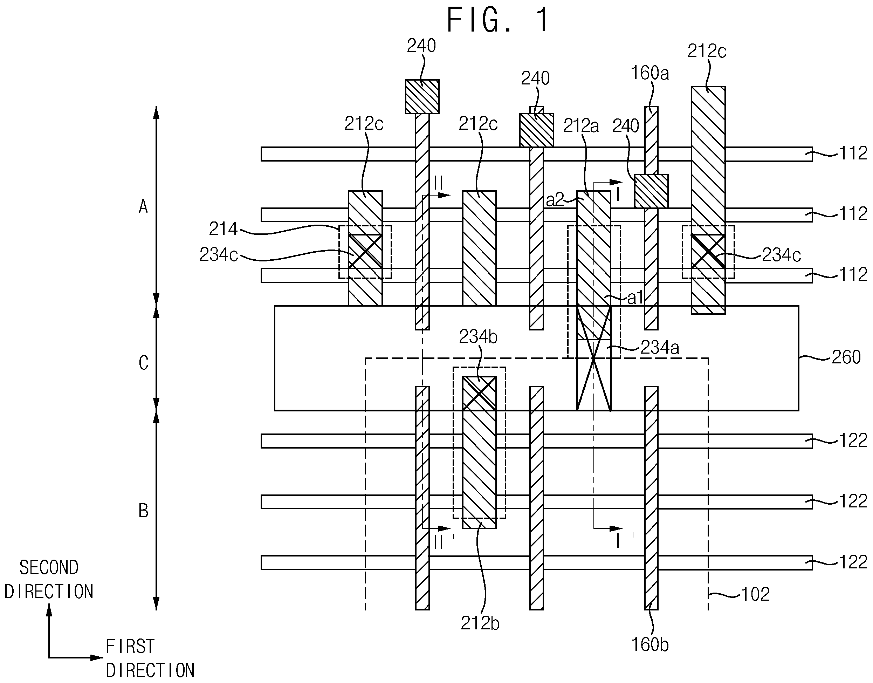

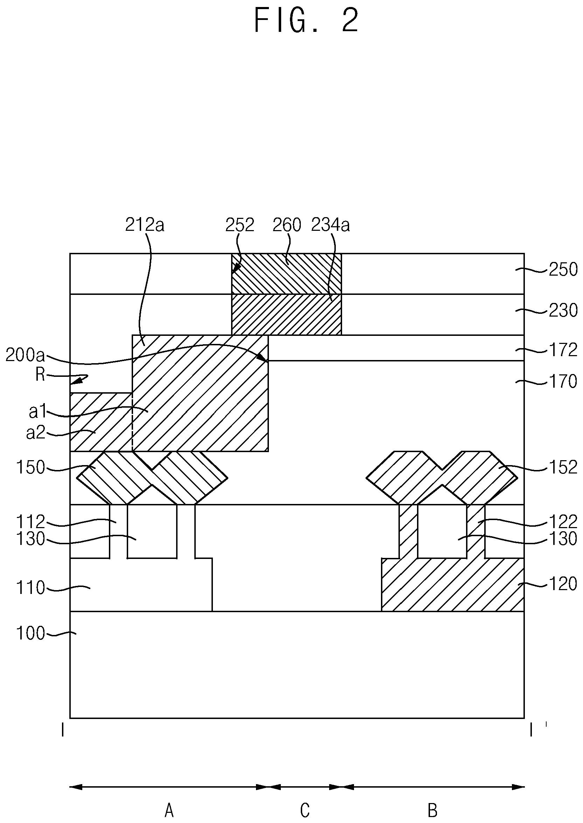

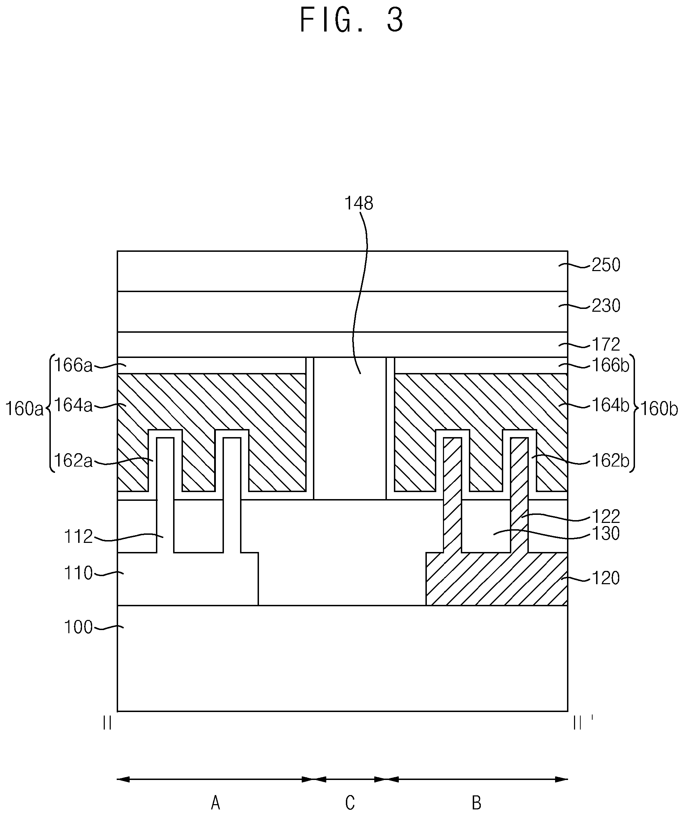

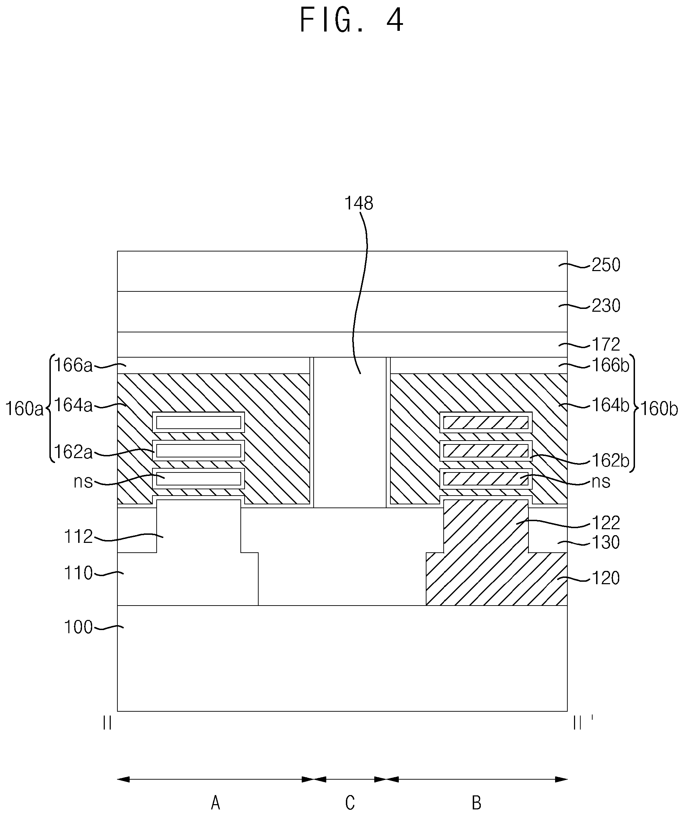

FIG 1 is a plan view of a semiconductor device in accordance with example embodiments of the inventive concept. FIG 2 is a cross-sectional view of a semiconductor device in accordance with example embodiments of the inventive concept. FIG 3 is a cross-sectional view of a semiconductor device in accordance with example embodiments of the inventive concept. FIG 4 is a cross-sectional view of a semiconductor device in accordance with example embodiments of the inventive concept.

FIG 2 is a cross-sectional view taken along line I-I' of FIG 1. FIGS. 3 and 4 are cross-sectional views taken along line II-II' of FIG 1, respectively. FIG 3 shows the semiconductor device including a fin field effect transistor (fin-FET). FIG 4 shows the semiconductor device including a multi-bridge channel field effect transistor (MBC-FET). In order to avoid drawing complexity, first and second semiconductor structures are omitted in each of the plan views.

Referring to FIGS. 1 to 3, a substrate 100 includes a p-channel metal-oxide-semiconductor (PMOS) region A, a boundary region C, and an N-well tap forming region B. The PMOS region A is a region for forming a PMOS FET. The N-well tap forming region B is a region for forming an N-well tap that is to be electrically connected to the PMOS FET. The boundary region C is disposed between the PMOS region A and the N-well tap forming region B.

Each of the PMOS region A, the N-well tap forming region B, and the boundary region C may extend in a first direction parallel to an upper surface of the substrate 100. The PMOS region A, the boundary region C, and the N-well tap forming region B may be sequentially arranged in a second direction parallel to the upper surface of the substrate 100 and perpendicular to the first direction. The N-well tap forming region B may face the PMOS region A in the second direction.

First, the PMOS FET formed on the PMOS region A of the substrate 100 is described. In example embodiments, the PMOS FET may include a fin FET or an MBC FET. The PMOS FET is described as the fin FET.

A first active pattern 110 extending in the first direction may be formed in the PMOS region A. First active fins 112 may protrude from an upper surface of the first active pattern 110, and may extend in the first direction. The first active fins 112 may be spaced apart from each other in the second direction.

An n-well region lightly doped with N-type impurities may be formed in the PMOS region A of the substrate 100.

An isolation pattern 130 may be formed between the first active fins 112. The isolation pattern 130 may partially cover sidewalls of the first active fins 112. The first active fins 112 may protrude from an upper surface of the isolation pattern 130. The isolation pattern 130 may include, e.g., silicon oxide.

A first gate structure 160a may be formed on the first active fins 112 and the isolation pattern 130, and may extend in the second direction to cross the first active fins 112. A plurality of first gate structures 160a may be spaced apart from each other in the first direction. The first gate structure 160a may include a first gate insulation layer 162a, a first gate pattern 164a, and a first upper capping pattern 166a.

An overlapping portion between the first active fin 112 and the first gate structure 160a may serve as a first channel region. In other words, an area where the first active fin 112 and the first gate structure 160a overlap may be a first channel region.

A first semiconductor pattern may be formed on the first active fin 112 that does not overlap with the first gate structure 160a. The first semiconductor patterns may be formed on the first active fin 112 adjacent to both sides of the first gate structure 160a, respectively.

The first semiconductor pattern may be doped with P-type impurities. Accordingly, the first semiconductor pattern may be an impurity region of the PMOS FET. The impurity region may serve as a source/drain region of the PMOS FET.

In example embodiments, the first semiconductor pattern may include silicon germanium. In the cross sectional view, as shown in FIG 2, the first semiconductor pattern may have a polygonal shape having a protruding central portion.

In example embodiments, the protruding central portions of adjacent first semiconductor patterns in the second direction may contact each other, so that the adjacent first semiconductor patterns in the second direction may be connected to each other. In this case, the adjacent first semiconductor patterns may serve as one first semiconductor structure 150. The first semiconductor structures 150 may electrically connect adjacent first active fins 112 therebelow. The first semiconductor structure 150 may serve as the impurity region of the PMOS FET.

As described above, the PMOS FET is formed on the PMOS region A of the substrate 100.

An N-well tap region 102 highly doped with n-type impurities is formed in the N-well tap forming region B of the substrate 100. The N-well tap region 102 is illustrated by the dashed lines in FIG 1, for example.

A second active pattern 120 may be formed on the N-well tap forming region B of the substrate 100, and may extend in the first direction. Second active fins 122 may protrude from an upper surface of the second active pattern 120, and may extend in the first direction. The second active fins 122 may be spaced apart from each other in the second direction.

Active fins may not be formed on the boundary region C of the substrate 100.

The isolation pattern 130 may be formed between the second active fins 122. The isolation pattern 130 may partially cover sidewalls of the second active fins 122. The second active fins 122 may protrude from the upper surface of the isolation pattern 130.

A second gate structure 160b may be formed on the second active fins 122, and may extend in the second direction to cross the second active fins 122. The second gate structure 160b may include a second gate insulation layer 162b, a second gate pattern 164b, and a second upper capping pattern 166b.

In example embodiments, the first and second gate structures 160a and 160b may be aligned in a line in the second direction.

End portions of the first and second gate structures 160a and 160b facing each other in the second direction may be positioned on the boundary region C. The end portions of the first and second gate structures 160a and 160b facing each other in the second direction may be spaced apart from each other. In other words, a gate structure having a line shape may be cut in the boundary region C to form separated the first and second gate structures 160a and 160b.

The first and second gate insulation layers 162a and 162b may be high dielectric layers including metal oxide. The first and second gate patterns 164a and 164b may include a metal material. The first and second upper capping patterns 166a and 166b may include, e.g., silicon nitride.

A second semiconductor pattern may be formed on the second active fin 122 that does not overlap with the second gate structure 160b. In other words, the second semiconductor pattern may be formed on the second active fin 122 adjacent to both sides of the second gate structure 160b. The second semiconductor pattern may be doped with N-type impurities.

In example embodiments, the second semiconductor pattern may include silicon. In the cross sectional view, the second semiconductor pattern may have a polygonal shape having a protruding central portion.

In example embodiments, the protruding central portions of adjacent second semiconductor patterns in the second direction may contact each other, so that the adjacent second semiconductor patterns in the second direction may be connected to each other. Thus, the adjacent second semiconductor patterns may serve as one second semiconductor structure 152. The second semiconductor structure 152 may electrically connect adjacent second active fins 122 therebelow.

As such, the N-well tap region 102 and the second semiconductor structure 152 connected to the N-well tap region 102 may be formed on the N-well tap forming region B of the substrate 100.

A first insulating interlayer 170 may cover the first semiconductor structure 150 and the second semiconductor structure 152. A second insulating interlayer 172 may be formed on the first insulating interlayer 170, and may cover the first and second gate structures 160a and 160b.

A first contact plug 240 may pass through the second insulating interlayer 172, the first insulating interlayer 170, and the first upper capping pattern 166a of the first gate structure 160a on the PMOS region A. Thus, the first contact plug 240 may contact the first gate pattern 164a. Electrical signals may be applied to the first gate pattern 164a through the first contact plug 240.

However, a contact plug may not be formed on the second gate structure 160b in the N-well tap forming region B. In this case, electrical signals may not be applied to the second gate pattern 164b included in the second gate structure 160b. Therefore, the second gate pattern 164b may not operate as an actual gate electrode.

A first wiring is electrically connected with one of the impurity regions of the PMOS FET and the N-well tap region 102. The first wiring electrically connects one of the impurity regions of the PMOS FET and the N-well tap region 102 to each other. A second wiring may be electrically connected with one of the impurity regions of the PMOS FET and the first gate pattern 164a. The second wiring may electrically connect one of the impurity regions of the PMOS FET and the first gate pattern 164a to each other.

A first metal pattern 212a is formed on an upper surface of at least one of the first semiconductor structures 150 serving as the impurity regions of the PMOS FET. The first metal pattern 212a may be formed in the first and second insulating interlayers 170 and 172. An uppermost surface of the first metal pattern 212a may be coplanar with an upper surface of the second insulating interlayer 172.

The first metal pattern 212a may cover at least a portion of the first semiconductor structure 150, and may extend in the second direction. The first metal pattern 212a may not cover the second semiconductor structure 152 facing the first semiconductor structure 150 in the second direction. One end of the first metal pattern 212a in the second direction is positioned on the boundary region C. One end of the first metal pattern 212a in the second direction may not extend to the N-well tap forming region B. A metal pattern may not be formed on the N-well tap forming region B facing the first metal pattern 212a in the second direction. The first metal pattern 212a may extend to the boundary region C.

In example embodiments, an upper surface of the first metal pattern 212a may include a recess portion R. The recess portion R of the first metal pattern 212a may be formed to reduce a parasitic capacitance and/or adjust a resistance between adjacent wirings. The first metal pattern 212a may include a first portion a1 and a second portion a2. The first portion a1 may have an upper surface having a first height, and the second portion a2 may have an upper surface having a second height different from the first height.

In some example embodiments, the upper surface of the first metal pattern 212a may not include the recess portion.

In example embodiments, the first metal pattern 212a may include, e.g., tungsten. A barrier metal pattern may be further formed along a sidewall and bottom of the first metal pattern 212a. The barrier metal pattern may include, e.g., titanium, titanium nitride, tantalum, or tantalum nitride.

A third insulating interlayer 230 may be formed on the first metal pattern 212a and the second insulating interlayer 172. A second contact plug 234a may pass through the third insulating interlayer 230, and may contact at least a portion of the first metal pattern 212a. The second contact plug 234a may be formed in a second contact hole passing through the third insulating interlayer 230 and exposing a portion of an upper surface of the first metal pattern 212a.

In example embodiments, a bottom of the second contact plug 234a may include a third portion contacting the first metal pattern 212a and a fourth portion not contacting the first metal pattern 212a. The fourth portion may contact the second insulating interlayer 172 on the boundary region C.

The second contact plug 234a may be disposed such that the second direction is a longitudinal direction. In example embodiments, in the cross-sectional view in the second direction, a width in the second direction of the third portion of the second contact plug 234a may be less than a width in the second direction of the fourth portion of the second contact plug 234a. In other words, more of the second contact plug 234a is in contact with the second insulating interlayer 172 than is in contact with the first metal pattern 212a.

The second contact plug 234a may include a metal material. In example embodiments, the second contact plug 234a may include tungsten. Barrier metal patterns may be further included along a sidewall and bottom of the second contact plug 234a. The barrier metal pattern may include, e.g., titanium, titanium nitride, tantalum, or tantalum nitride.

The recess portion R of the upper surface of the first metal pattern 212a may be spaced apart from a contact surface between the first metal pattern 212a and the second contact plug 234a.

The first metal pattern 212a contacts the first semiconductor structure 150, and may not contact the second semiconductor structures 152 connected to the N-well tap region 102. In example embodiments, a metal pattern may not be formed on the second semiconductor structure 152 facing the first metal pattern 212a in the second direction. In one example, a metal pattern may not be disposed in an area of the N-well tap forming region that faces the first metal pattern in an extending direction of the first metal pattern. Accordingly, a metal pattern directly connecting between upper portions of the first semiconductor structure 150 and the second semiconductor structure 152 is not be formed.

If the first metal pattern directly connects between the first semiconductor structure serving as the impurity region of the PMOS FET and the second semiconductor structure connected to the N-well tap region, anodic corrosion may occur on an upper surface of the second contact plug formed on the first metal pattern. In this case, a metal of an upper portion of the second contact plug may be consumed by the anodic corrosion, and thus the second contact plug may not completely fill the second contact hole. As the upper portion of the second contact plug is consumed, a contact resistance between the second contact plug and an upper wiring contacting an upper surface of the second contact plug may be increased. Therefore, electrical defects may occur.

However, in example embodiments, the first metal pattern 212a does not contact the first semiconductor structure 150, and may not extend to (for example, may not directly connect) the second semiconductor structure 152 adjacent the first semiconductor structure 150 in the second direction. Therefore, anodic corrosion may not occur on the upper surface of the second contact plug 234a formed on the first metal pattern 212a. A metal of an upper portion of the second contact plug 234a may not be consumed, so that the second contact plug 234a may completely fill the second contact hole. In example embodiments, the upper surface of the second contact plug 234a may be substantially coplanar with an upper surface of the third insulating interlayer 230.

A second metal pattern 212b is formed on at least one of the second semiconductor structures 152 in the N-well tap region 102.

The second metal pattern 212b may cover at least a portion of the second semiconductor structure 152, and may extend in the second direction. The second metal pattern 212b may not cover the first semiconductor structure 150 facing the second semiconductor structure 152 in the second direction. One end of the second metal pattern 212b in the second direction may be positioned on the boundary region C. The one end of the second metal pattern 212b in the second direction may not extend to the PMOS region A. The second metal pattern 212b may extend to the boundary region C. In other words, the second metal pattern 212b may overlap the boundary region C.

In example embodiments, an upper surface of the second metal pattern 212b may include a recess portion. Accordingly, the second metal pattern 212b may include a fifth portion and a sixth portion. The fifth portion may have an upper surface having a third height, and the sixth portion may have an upper surface having a fourth height different from the third height. In some example embodiments, the upper surface of the second metal pattern 212b may not include the recess portion.

The first and second metal patterns 212a and 212b are not aligned with each other in the second direction. In one example, the first and second metal patterns may not be aligned in a line in the second direction. In example embodiments, the second metal pattern 212b and the first metal pattern 212a may be disposed in an oblique direction with respect to the second direction.

A third contact plug 234b is formed on the second metal pattern 212b.

A third metal pattern 212c may be formed on at least one of the first semiconductor structures 150 serving as the impurity region of the PMOS FET. The third metal pattern 212c may cover at least a portion of the first semiconductor structure 150. In example embodiments, the third metal pattern 212c may be disposed on the PMOS region A. Both ends of the third metal pattern 212c in the second direction may be positioned on the PMOS region A.

In example embodiments, an upper surface of the third metal pattern 212c may include a recess portion. In some example embodiments, the upper surface of the third metal pattern 212c may not include the recess portion.

A fourth contact plug 234c may be formed on the third metal pattern 212c. The fourth contact plug 234c may be disposed in the PMOS region A.

The recess portion of the upper surface of the third metal pattern 212c may be spaced apart from a contact surface between the third metal pattern 212c and the fourth contact plug 234c.

In example embodiments, the second and third metal patterns 212b and 212c may include a material the same as a material of the first metal pattern 212a. For example, the second and third metal patterns 212b and 212c may include tungsten.

In example embodiments, the third and fourth contact plugs 234b and 234c may include a metal the same as a metal of the second contact plug 234a. For example, the third and fourth contact plugs 234b and 234c may include tungsten.

A fourth insulating interlayer 250 may be formed on the third insulating interlayer 230. An upper wiring line 260 may pass through the fourth insulating interlayer 250, and may extend in the first direction to contact upper surfaces of the second and third contact plugs 234a and 234b. The upper wiring line 260 may cover the second and third contact plugs 234a and 234b

In example embodiments, in a cross-sectional view in the second direction, a width of the upper wiring line 260 in the second direction may be substantially the same as a width of the second contact plug 234a thereunder in the second direction.

The upper wiring line 260 may include metal. In example embodiments, the upper wiring line 260 may include copper.

As described above, at least one of the impurity regions of the PMOS FET and the N-well tap region 102 may be electrically connected by the upper wiring line 260, the second and third contact plugs 234a and 234b, and the first and second metal patterns 212a and 212b. The upper wiring line 260, the second and third contact plugs 234a and 234b, and the first and second metal patterns 212a and 212b serve as the first wiring for electrically connecting at least one of the impurity regions of the PMOS FET and the N-well tap region 102 to each other.

The first wiring may not include a metal pattern directly connecting between at least one of the impurity regions of the PMOS FET and the second semiconductor structure connected to the N-well tap region 102. Accordingly, electrical defects caused by the metal pattern directly connecting between at least one of the impurity regions of the PMOS FET and the second semiconductor structure connected to the N-well tap region may be decreased.

A first upper wiring electrically connected to the first contact plug 240 and a second upper wiring electrically connected to the fourth contact plug 234c may be further formed on the first contact plug 240 and the fourth contact plug 234c, respectively. The first contact plug 240, the first upper wiring, the fourth contact plug 234c and the second upper wiring may serve as the second wiring.

Although the semiconductor device has described the PMOS FET as the fin field effect transistor, it may not be limited thereto. For example, the PMOS FET may be the MBC-FET.

Hereinafter, the PMOS FET is described as the MBC FET, with reference to FIG 4. A description overlapping with the description with reference to FIGS. 1 to 3 may be omitted.

Referring to FIG 4, a first gate structure 160a may be formed on the first active fins 112 and the isolation pattern 130. A plurality of first gate structures 160a may extend in the second direction to cross the first active fins 112.

A portion of the first active fins 112 overlapping the first gate structure 160a may have a nano sheet structure. The nano sheet structure may include nano sheets (ns) spaced apart from each other in a vertical direction, and may include a gap between the nano sheets (ns). The first gate structure 160a may extend to fill the gap of the nano sheet structure.

A second gate structure 160b may be formed on the second active fins 122 and the isolation pattern 130. A plurality of second gate structures 160b may extend in the second direction to cross the second active fins 122.

A portion of the second active fins 122 overlapping the second gate structure 160b may have a nano sheet structure. The nano sheet structure may include nano sheets (ns) spaced apart from each other in the vertical direction, and may include a gap between the nano sheets (ns). The second gate structure 160b may extend to fill the gap of the nano sheet structure.

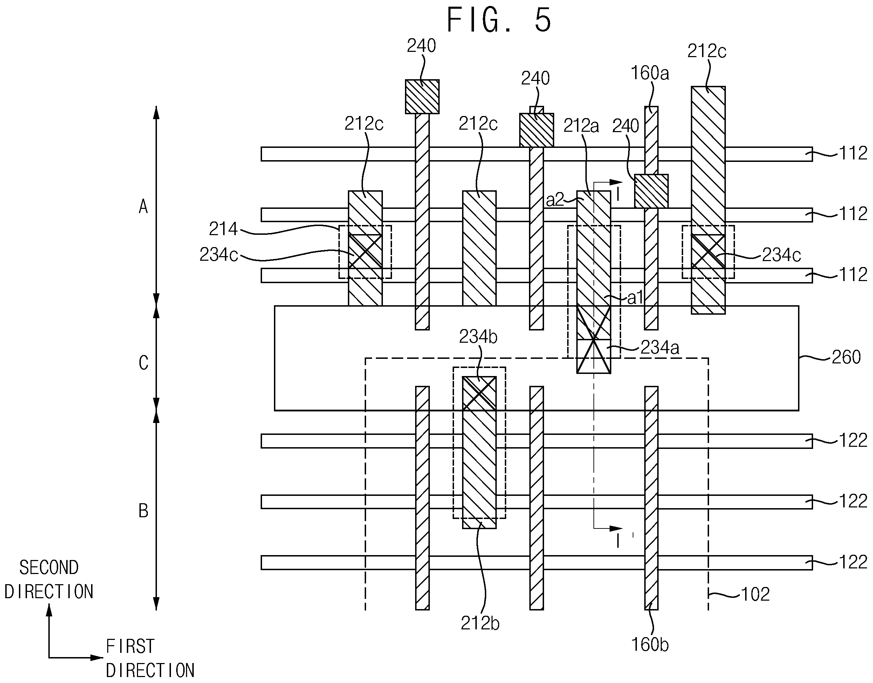

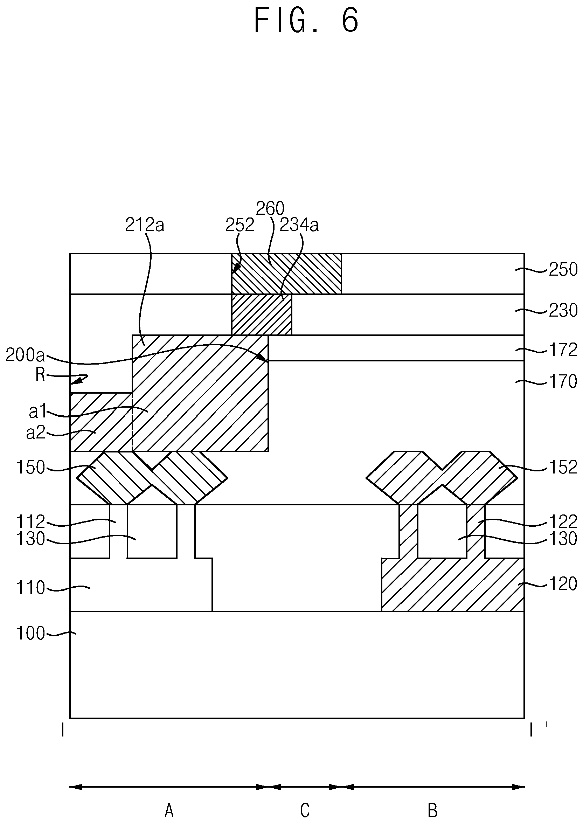

FIG 5 is a plan view of a semiconductor device in accordance with example embodiments of the inventive concept. FIG 6 is a cross-sectional view of a semiconductor device in accordance with example embodiments of the inventive concept.

FIG 6 is a cross-sectional view taken along line I-I' of FIG 5.

The semiconductor device shown in FIGS. 5 and 6 is the same as the semiconductor device described with reference to FIGS. 1 to 3, except for a shape of the second contact plug. Therefore, redundant descriptions are omitted.

Referring to FIGS. 5 and 6, the second contact plug 234a may be disposed such that the second direction is a longitudinal direction.

In example embodiments, in the cross-sectional view in the second direction, a width in the second direction of a third portion of the second contact plug 234a contacting the first metal pattern 212a may be equal to or greater than a width in the second direction of a fourth portion of the second contact plug 234a contacting the second insulating interlayer 172.

In example embodiments, in the cross-sectional view in the second direction, a width of the upper wiring line 260 in the second direction may be greater than a width of the second contact plug 234a thereunder in the second direction.

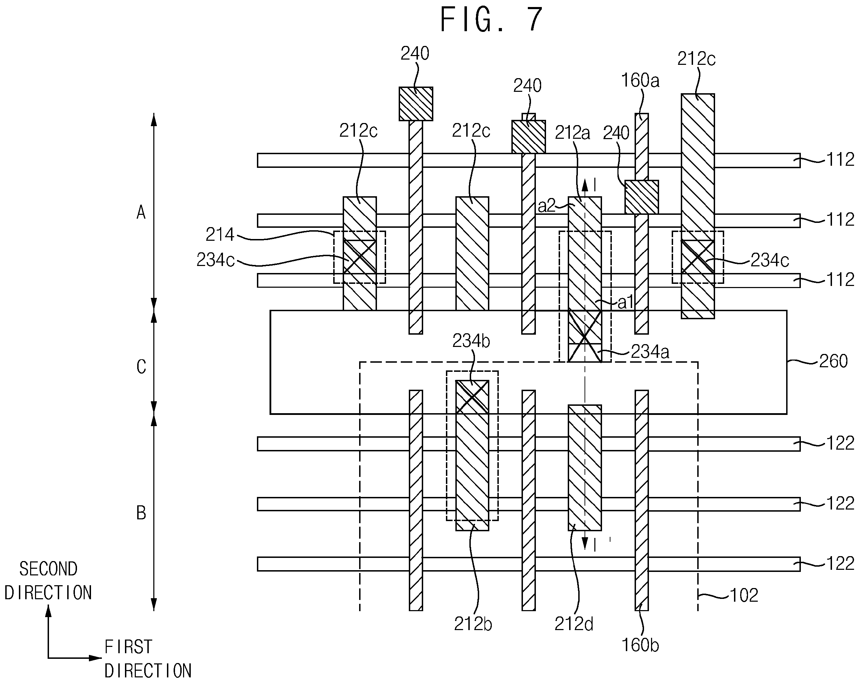

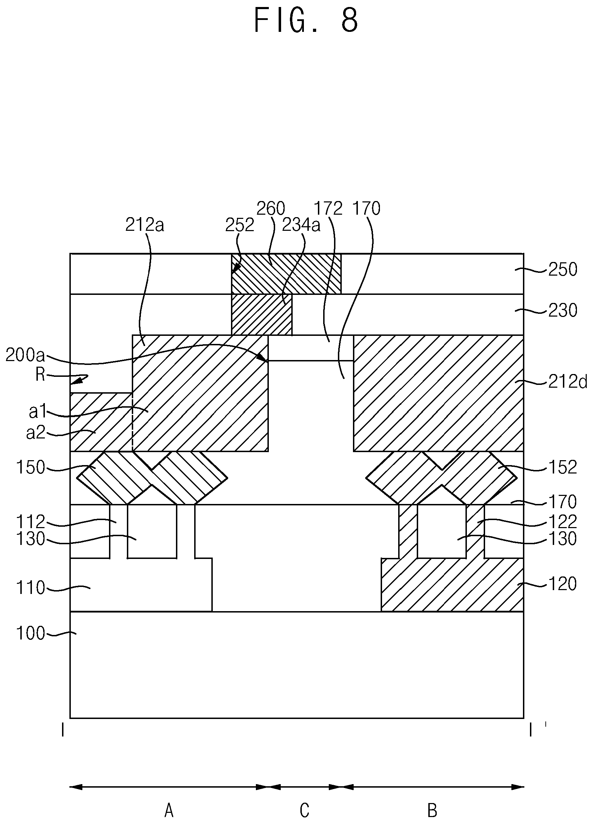

FIG 7 is a plan view of a semiconductor device in accordance with example embodiments of the inventive concept. FIG 8 is a cross-sectional view of a semiconductor device in accordance with example embodiments of the inventive concept.

FIG. 8 is a cross-sectional view taken along line I-I' of FIG 7.

The semiconductor device shown in FIGS. 7 and 8 is the same as the semiconductor device described with reference to FIGS. 1 to 3, except for a fourth metal pattern and a shape of the second contact plug. Therefore, redundant descriptions are omitted.

Referring to FIGS. 7 and 8, the first metal pattern 212a is formed on at least one of the first semiconductor structures 150 in the PMOS region A. The first metal pattern 212a may not cover the second semiconductor structure 152 facing the first semiconductor structure 150 in the second direction. The first metal pattern 212a may be the same as that described with reference to FIGS. 1 to 3.

A second contact plug 234a is formed on the first metal pattern 212a. In example embodiments, a bottom of the second contact plug 234a may include a third portion contacting the first metal pattern 212a and a fourth portion contacting the second insulating interlayer 172 on the boundary region C.

The second contact plug 234a may be disposed such that the second direction is a longitudinal direction. In example embodiments, in a cross-sectional view in the second direction, a width in the second direction of the third portion of the second contact plug 234a may be greater than a width in the second direction of the fourth portion of the second contact plug 234a.

A second metal pattern 212b is formed on at least one of the second semiconductor structures 152 in the N-well tap region 102. The second metal pattern 212b may be the same as that described with reference to FIGS. 1 to 3. A third contact plug 234b is formed on the second metal pattern 212b.

A third metal pattern 212c may be formed on at least one of the first semiconductor structures 150 serving as the impurity region of the PMOS FET. The third metal pattern 212c may be the same as that described with reference to FIGS. 1 to 3. In one example, the third metal pattern may be spaced apart from the first metal pattern. A fourth contact plug 234c may be formed on the third metal pattern 212c.

A fourth metal pattern 212d may be formed on at least one of the second semiconductor structures 152 on the N-well tap region 102. In example embodiments, the fourth metal pattern 212d may be aligned with the first metal pattern 212a in the second direction. End portions of the first and fourth metal patterns 212a and 212d facing each other in the second direction may be spaced apart from each other. In other words, a metal pattern having a line shape may be cut to form separated the first and fourth metal patterns 212a and 212d.

One end of the fourth metal pattern 212d in the second direction may be positioned on the boundary region C. The one end of the fourth metal pattern 212d in the second direction may not extend to the PMOS region A.

A contact plug may not be formed on an upper surface of the fourth metal pattern 212d. In other words, the fourth metal pattern 212d may not be electrically connected to other patterns. First and second insulating interlayers 170 and 172 may be formed on a region between the first and fourth metal patterns 212a and 212d.

The second contact plug 234a may not extend to the fourth metal pattern 212d.

As such, the first and fourth metal patterns 212a and 212d may be aligned in a line in the second direction. In addition, the first and second metal patterns 212a and 212b are not aligned to each other in the second direction.

An upper wiring line 260 extends in the first direction to contact upper surfaces of the second and third contact plugs 234a and 234b. One of the impurity regions of the PMOS FET and the N-well tap region 102 may be electrically connected by the upper wiring line 260, the second and third contact plugs 234a and 234b, and the first and second metal patterns 212a and 212b.

In example embodiments, in the cross-sectional view in the second direction, a width of the upper wiring line 260 in the second direction may be greater than a width of the second contact plug 234a thereunder in the second direction. Accordingly, the lower surface of the upper wiring line 260 may include a fifth portion contacting the second contact plug 234a and a sixth portion contacting the third insulating interlayer 230 on the boundary region C.

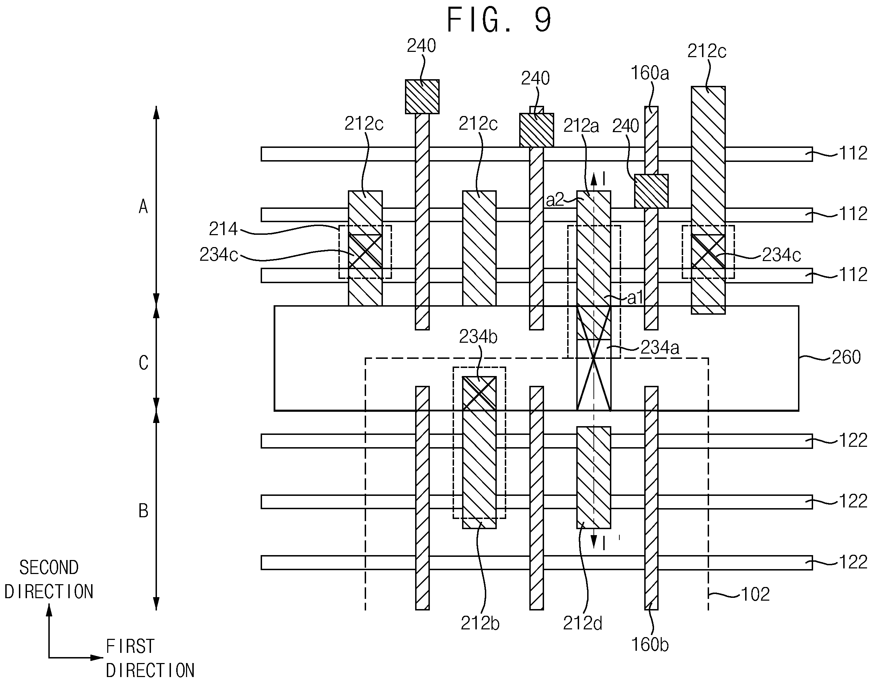

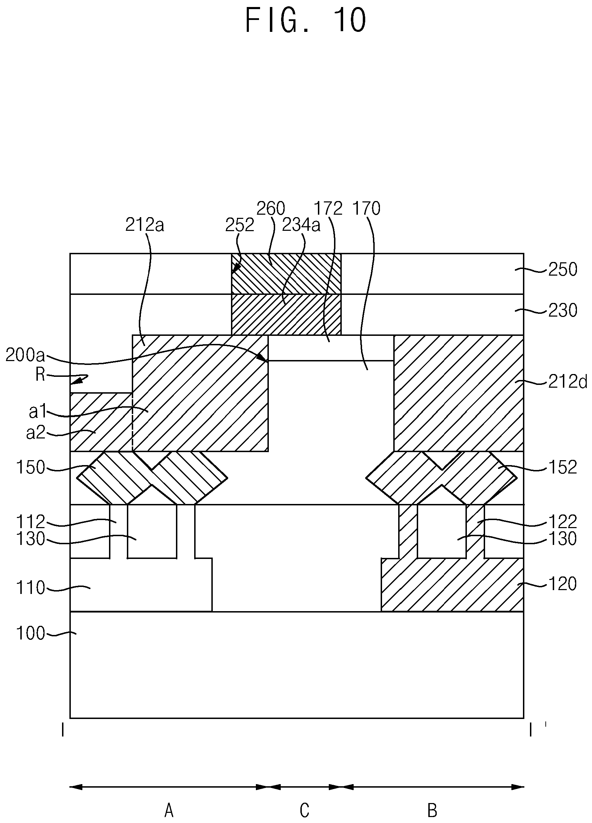

FIG 9 is a plan view of a semiconductor device in accordance with example embodiments of the inventive concept. FIG 10 is a cross-sectional view of a semiconductor device in accordance with example embodiments of the inventive concept.

FIG 10 is a cross-sectional view taken along line I-I' of FIG 9.

The semiconductor device shown in FIGS. 9 and 10 is the same as the semiconductor device described with reference to FIGS. 7 and 8, except for shapes of the fourth metal pattern and the second contact plug. Therefore, redundant descriptions are omitted.

Referring to FIGS. 9 and 10, a fourth metal pattern 212d may be formed on at least one of the second semiconductor structures 152 on the N-well tap region 102. The fourth metal pattern 212d may be aligned with the first metal pattern 212a in the second direction. End portions of the first and fourth metal patterns 212a and 212d facing each other in the second direction may be spaced apart from each other. In other words, a metal pattern having a line shape may be cut to form separated the first and fourth metal patterns 212a and 212d.

One end of the fourth metal pattern 212d in the second direction may be positioned on the N-well tap forming region B. The one end of the fourth metal pattern 212d in the second direction may not extend to the boundary region C. A contact plug may not be formed on an upper surface of the fourth metal pattern 212d.

In example embodiments, a length of the first metal pattern 212a in the second direction may be longer than a length of the fourth metal pattern 212d in the second direction.

The second contact plug 234a may be disposed such that the second direction is a longitudinal direction. In example embodiments, in the cross-sectional view in the second direction, a width in the second direction of a third portion of the second contact plug 234a contacting the first metal pattern 212a may be equal to or less than a width in the second direction of a fourth portion of the second contact plug 234a contacting the second insulating interlayer 172. The second contact plug 234a may not extend to an upper surface of the fourth metal pattern 212d.

An upper wiring line 260 may extend in the first direction to contact upper surfaces of the second and third contact plugs 234a and 234b. One of the impurity regions of the PMOS FET and the N- well tap region 102 may be electrically connected by the upper wiring line 260, the second and third contact plugs 234a and 234b, and first and second metal patterns 212a and 212b.

In example embodiments, in the cross-sectional view in the second direction, a width of the upper wiring line 260 in the second direction may be substantially the same as a width of the second contact plug 234a thereunder in the second direction.

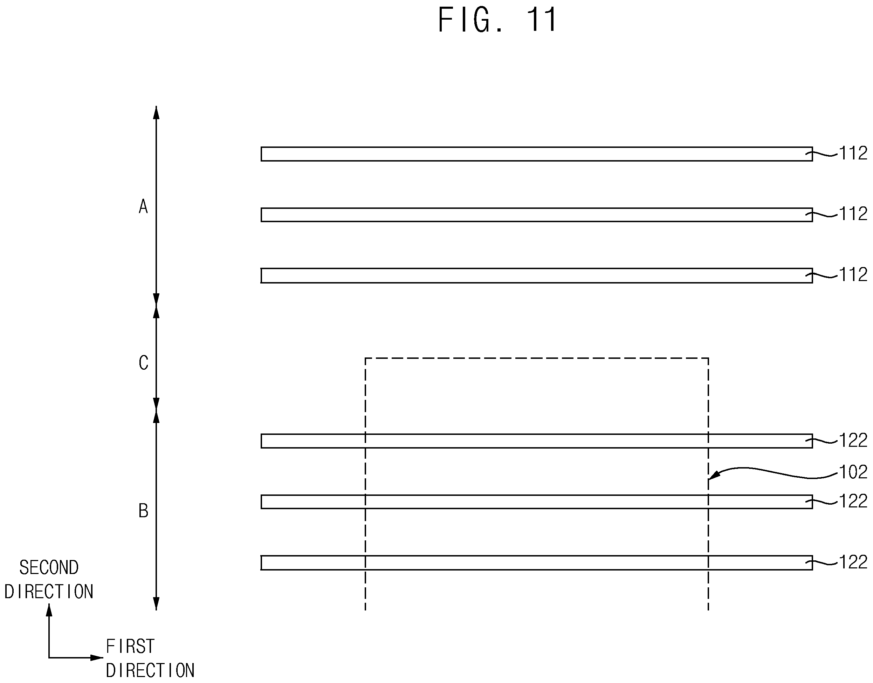

FIGS. 11 to 28 are cross-sectional views and plan views illustrating a method of manufacturing a semiconductor device in accordance with example embodiments of the inventive concept.

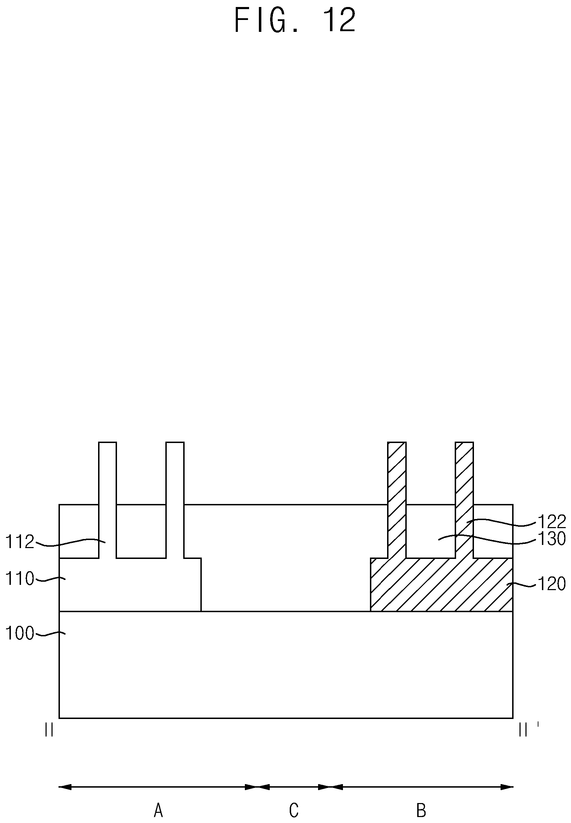

FIGS. 11, 13, 16, 18, 20, 22, 24, 25 and 27 are plan views, and FIGS. 12, 14, 15, 17, 19, 21, 23, 26 and 28 are cross-sectional views. FIGS. 12, 15, 19, 21, 23, 26 and 28 are cross-sectional views taken along line I-I' of FIG 1, and FIGS. 14 and 17 are cross-sectional views taken along line II-II' of FIG 1.

Referring to FIGS. 11 and 12, n-type impurities may be lightly doped into a PMOS region A, a boundary region C, and a N-well tap forming region B of the substrate 100 to form an n-well region. N-type impurities may be heavily doped into a portion of the N-well tap forming region B of the substrate 100 to form an N-well tap region 102. In example embodiments, n-type impurities may be also heavily doped into a portion of the boundary region C, and in this case, the N-well tap region 102 may extend to a portion of the boundary region C.

A portion of the substrate 100 may be etched to form preliminary active patterns extending in the first direction and preliminary active fins extending in the first direction on the preliminary active pattern. The preliminary active fins formed on the boundary region C of the substrate 100 may be removed, and preliminary active patterns therebetween may be removed to form a first active pattern 110, first active fins 112, a second active pattern 120 and second active fins 122.

The first active pattern 110 may be formed on the PMOS region A of the substrate 100, and may extend in the first direction. The first active fins 112 may be formed on the first active pattern 110. The first active fins 112 may protrude from an upper surface of the first active pattern 110, and may extend in the first direction. The second active pattern 120 may be formed on the N-well tap forming region B of the substrate 100, and may extend in the first direction. The second active fins 122 may be formed on the second active pattern 120. The second active fins 122 may protrude from an upper surface of the second active pattern 120, and extend in the first direction. In addition, a deep isolation trench may be formed at a portion of the boundary region C where the preliminary active patterns are removed.

An isolation pattern 130 may be formed between the first active fins 112, the second active fins 122, and the deep isolation trench. The isolation pattern 130 may partially cover sidewalls of the first active fins 112 and sidewalls of the second active fins 122. Thus, each of the first and second active fins 112 and 122 may protrude from the upper surface of the isolation pattern 130. The isolation pattern 130 may include, e.g., silicon oxide.

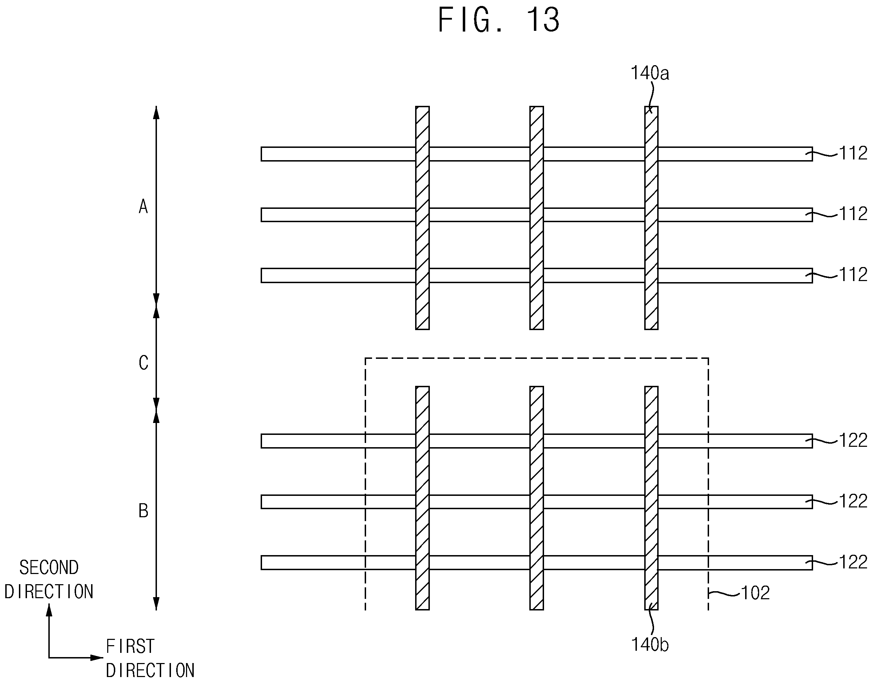

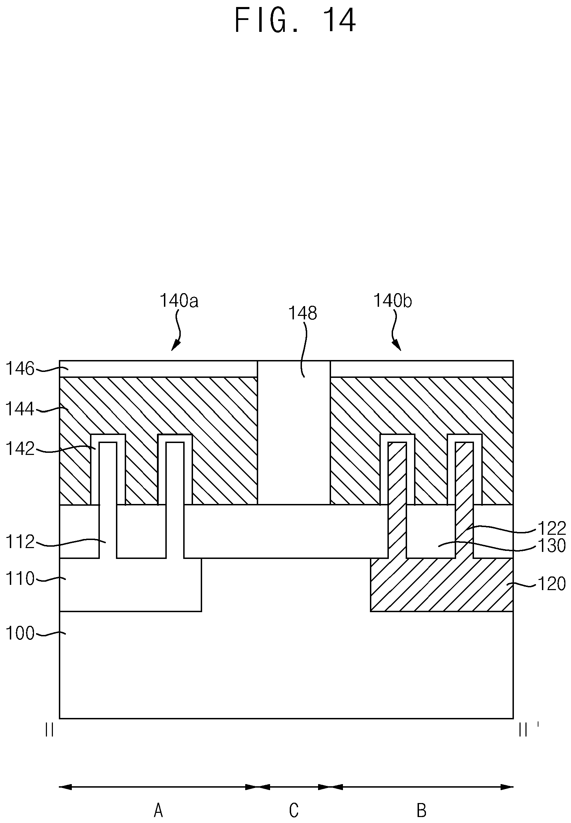

Referring to FIGS. 13 and 14, a first dummy gate structure 140a crossing the first active fins 112 and a second dummy gate structure 140b crossing the second active fins 122 may be formed on the first active fins 112, the second active fins 122 and the isolation pattern 130. An insulation pattern 148 may be formed on the first active fins 112, the second active fins 122 and the isolation pattern 130 between the first and second dummy gate structures 140a and 140b. For example, the insulation pattern 148 may be disposed between the first dummy gate structure 140a and the second dummy gate structure 140b. A spacer may be formed on a sidewall of each of the first and second dummy gate structures 140a and 140b.

In example embodiments, the first and second dummy gate structures 140a and 140b may be formed by cutting a dummy gate structure positioned on the boundary region C, after forming the dummy gate structure extending in the second direction.

In example embodiments, each of the first and second dummy gate structures 140a and 140b may include a dummy gate insulation layer 142, a dummy gate pattern 144 and a first capping pattern 146. The dummy gate insulation layer 142 may include, e.g., silicon oxide. The dummy gate pattern 144 may include, e.g., polysilicon. The first capping pattern 146 may include, e.g., silicon nitride.

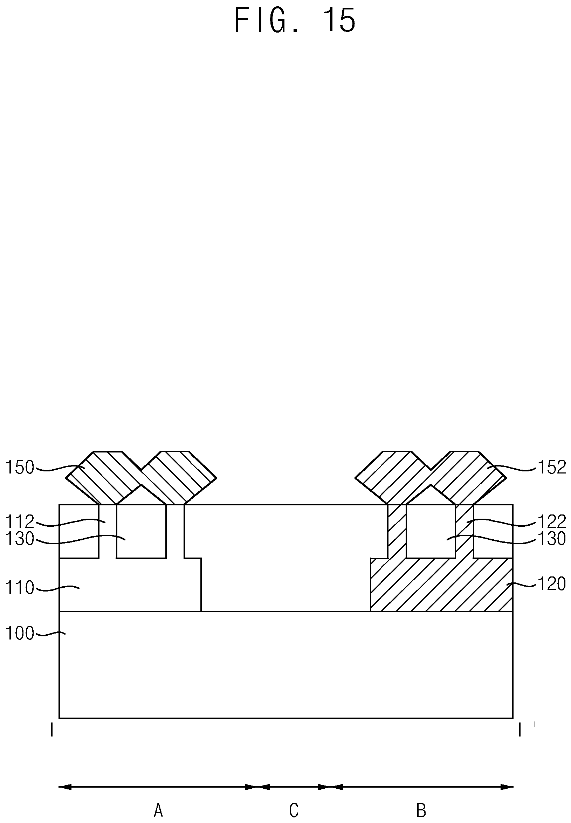

Referring to FIG 15, the first active fin 112 adjacent to both sides of the first dummy gate structure 140a may be partially removed to form first recesses. A first semiconductor pattern may be formed in each of the first recesses by performing a selective epitaxial growth (SEG) process. In example embodiments, the first semiconductor pattern may include silicon germanium. P-type impurities may be doped into the first semiconductor pattern. The first semiconductor pattern may be an impurity region serving as a source/drain region of a PMOS FET.

In the cross sectional view, the first semiconductor pattern may have a polygonal shape having a protruding central portion. The protruding central portions of adjacent first semiconductor patterns in the second direction may contact to each other. Thus, the first semiconductor patterns may serve as one first semiconductor structure 150.

The second active fins 122 adjacent to both sides of the second dummy gate structure 140b may be partially removed to form second recesses. A second semiconductor pattern may be formed in each of the second recesses by performing a selective epitaxial growth (SEG) process. In example embodiments, the second semiconductor pattern may include silicon. N-type impurities may be doped into the second semiconductor pattern. The second semiconductor pattern may be connected to the N-well tap region 102.

In the cross sectional view, the second semiconductor pattern may have a polygonal shape having a protruding central portion. The protruding central portions of adjacent second semiconductor patterns in the second direction may contact each other. Thus, the second semiconductor patterns may serve as one second semiconductor structure 152.

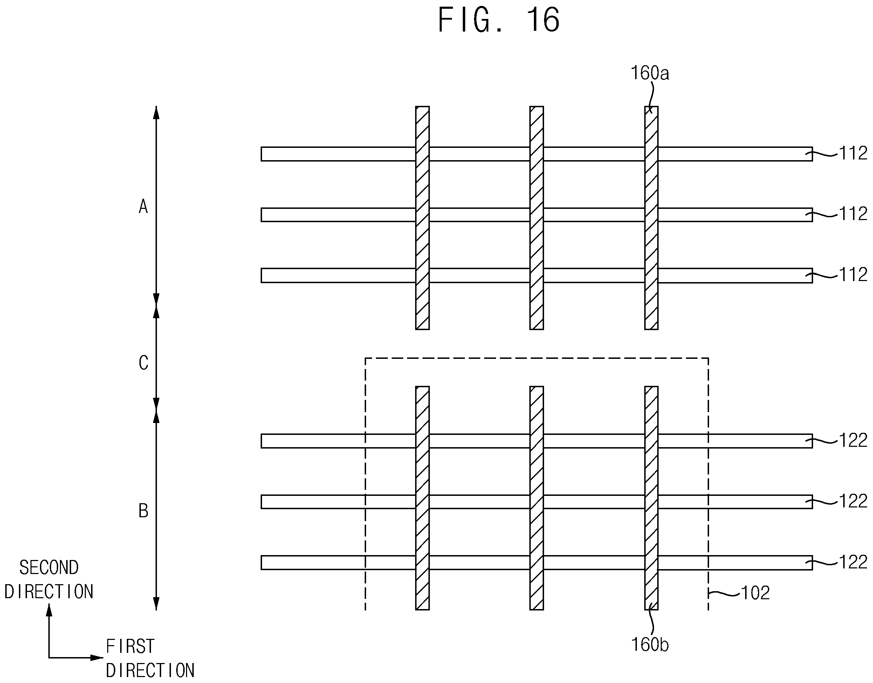

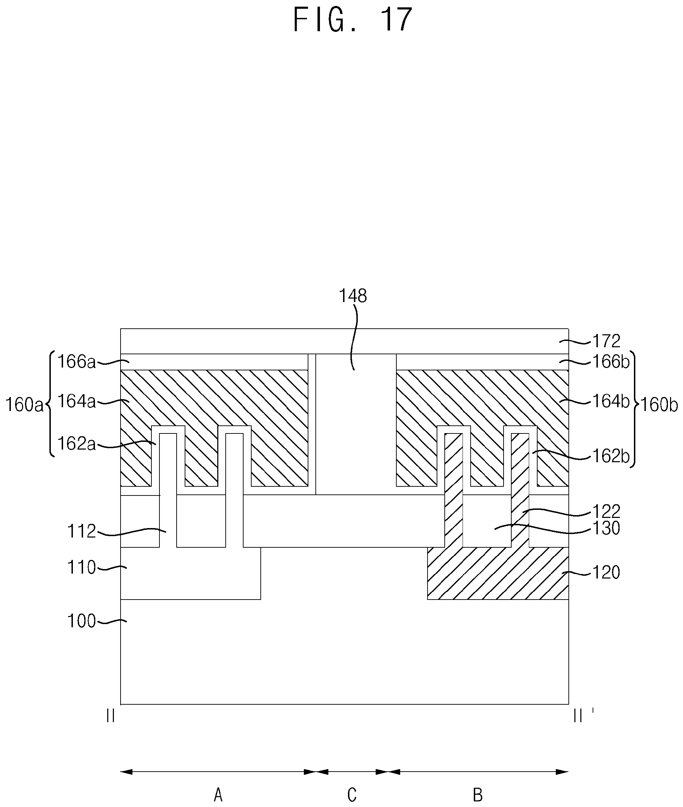

Referring to FIGS. 16 and 17, a first insulating interlayer may be formed to cover the first semiconductor structure 150 and the second semiconductor structure 152. The first insulating interlayer may be planarized until upper surfaces of the first and second dummy gate structures 140a and 140b may be exposed. Thereafter, the first and second dummy gate structures 140a and 140b may be removed to form first and second trenches, respectively. First and second gate structures 160a and 160b may be formed in the first and second trenches, respectively.

In example embodiments, the first gate structure 160a may include a first gate insulation layer 162a, a first gate pattern 164a, and a first upper capping pattern 166a. The second gate structure 160b may include a second gate insulation layer 162b, a second gate pattern 164b, and a second upper capping pattern 166b.

A second insulating interlayer 172 may be formed to cover the first and second gate structures 160a and 160b and the insulation pattern 148.

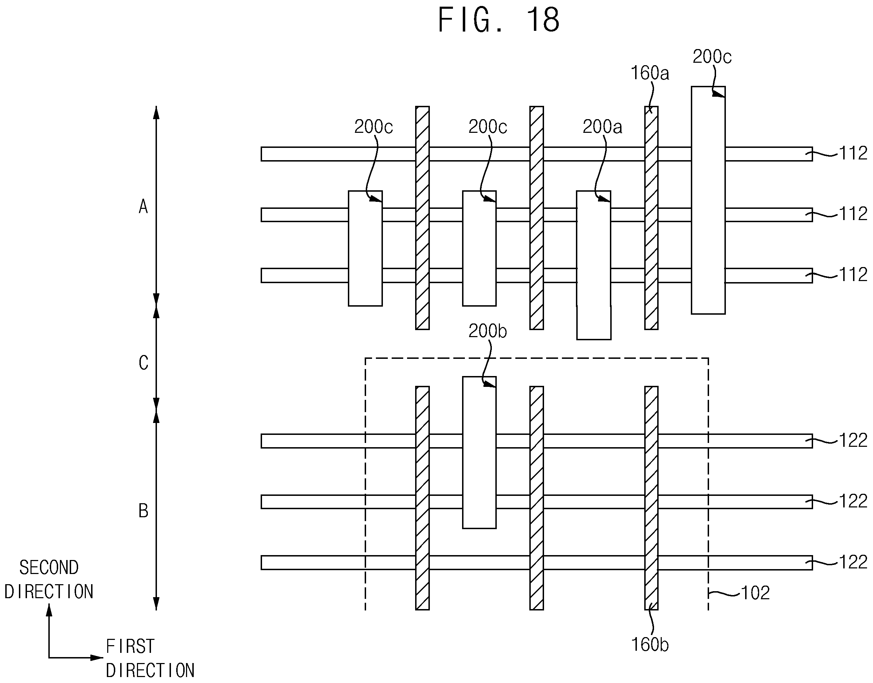

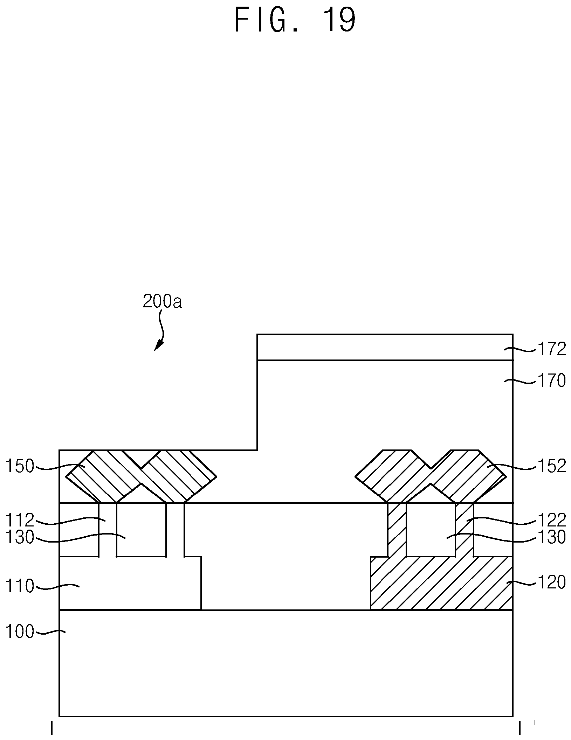

Referring to FIGS. 18 and 19, the second insulating interlayer 172 and the first insulating interlayer 170 may be etched to form a first opening 200a, a second opening 200b, and a third opening 200c, respectively.

The first opening 200a may be formed on at least one of the first semiconductor structures 150 of the PMOS region A. The first opening 200a may be disposed so that the second direction is a longitudinal direction. The first opening 200a may not expose the second semiconductor structure 152 facing the first semiconductor structure 150. In other words, the second insulating interlayer 172 and the first insulating interlayer 170 may remain on the second semiconductor structure 152 facing the first semiconductor structure 150. In example embodiments, the first opening 200a may extend from an upper surface of the first semiconductor structure 150 to the boundary region C in the second direction. In example embodiments, a portion of the upper surface of the first semiconductor structure 150 and the first insulating interlayer 170 on the boundary region C may be exposed by a bottom of the first opening 200a. In the etching process, an upper portion of the first semiconductor structure 150 may be partially removed. Through subsequent processes, the first opening 200a may be formed as a wiring for electrically connecting one of the impurity regions of the PMOS FET and the N-well tap region 102.

The second opening 200b may be formed on at least one of the second semiconductor structures 152 on the N-well tap region 102. The second opening 200b may not be aligned with the first opening 200a in the second direction. The second opening 200b may be disposed so that the second direction is the longitudinal direction. The second opening 200b may not expose the first semiconductor structure 150 facing the second semiconductor structure 152. In example embodiments, the second opening 200b may extend from an upper surface of the second semiconductor structure 152 to the boundary region C in the second direction. In example embodiments, a portion of the upper surface of the second semiconductor structure 152 and the first insulating interlayer 170 on the boundary region C may be exposed by a bottom of the second opening 200b. In the etching process, an upper portion of the second semiconductor structure 152 may be partially removed. Through subsequent processes, the second opening 200b may be formed as a wiring for electrically connecting one of impurity regions of the PMOS FET and the N-well tap region 102.

The third opening 200c may be formed on at least one of the first semiconductor structures 150 serving as impurity regions of the PMOS FET. A wiring filling in the third opening 200c through subsequent processes may not be electrically connected with the PMOS FET and the N-well tap region 102. In example embodiments, a portion of the upper surface of the first semiconductor structure 150 may be exposed by a bottom of the third opening 200c, and the first insulating interlayer 170 on the boundary region C may not be exposed by the bottom of the third opening 200c.

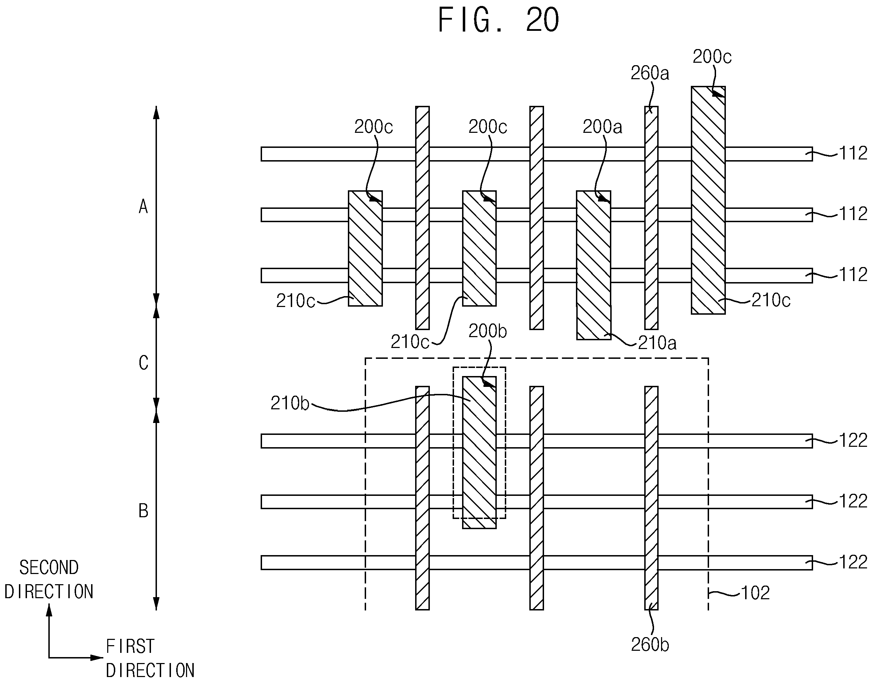

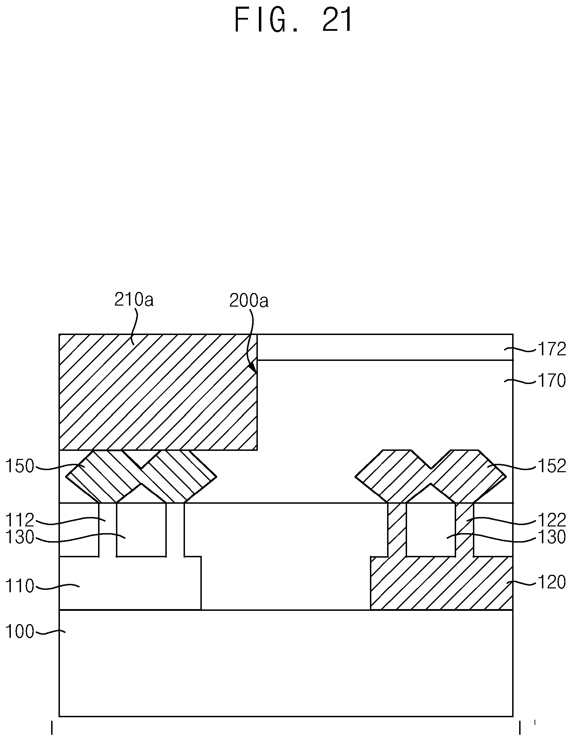

Referring to FIGS. 20 and 21, a first metal layer may be formed on the second insulating interlayer 172 to fill the first to third openings 200a, 200b, and 200c. The first metal layer may include, e.g., tungsten.

Thereafter, the first metal layer may be planarized until an upper surface of the second insulating interlayer 172 may be exposed to form first, second and third preliminary metal patterns 210a, 210b and 210c, respectively. The first preliminary metal pattern 210a may be formed in the first opening 200a. The second preliminary metal pattern 210b may be formed in the second opening 200b. The third preliminary metal pattern 210c may be formed in the third opening 200c.

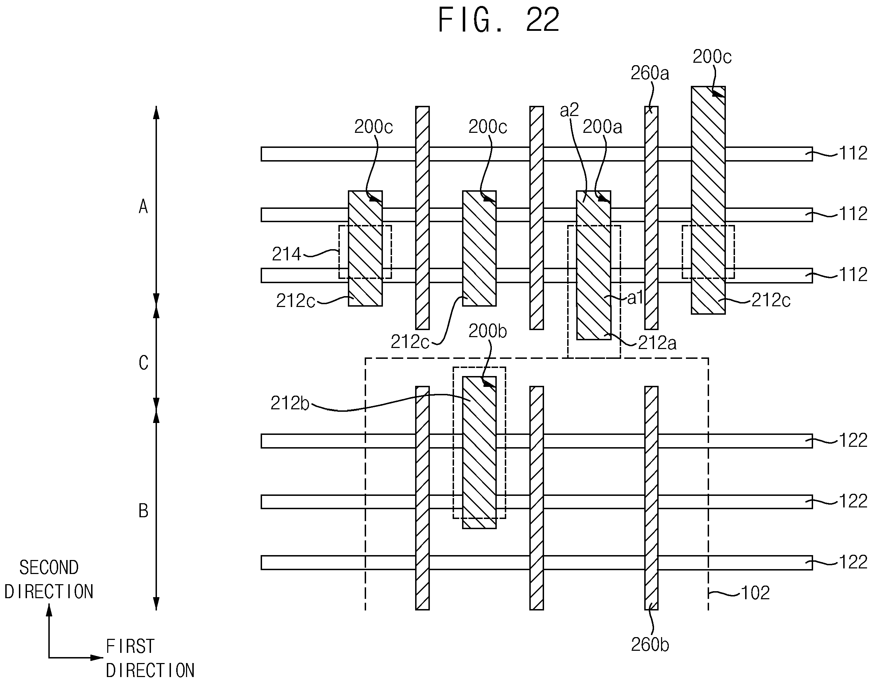

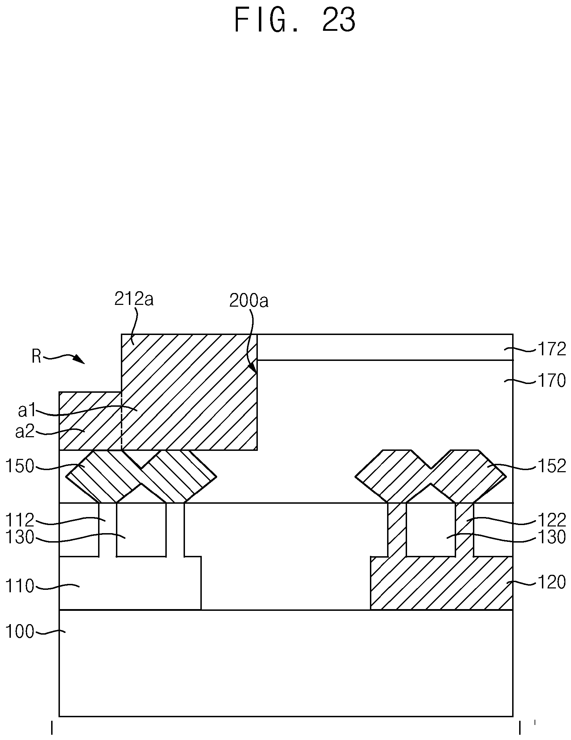

Referring to FIGS. 22 and 23, an etch mask pattern 214 may be formed to cover portions of the first to third preliminary metal patterns 210a, 210b, and 210c. Upper portions of the first to third preliminary metal patterns 210a, 210b, and 210c may be partially etched using the etch mask pattern 214 to form first, second and third metal patterns 212a, 212b and 212c, respectively.

The first to third metal patterns 212a, 212b, and 212c covered by the etching mask pattern 214 may have a first thickness. The first thickness may be substantially the same as thicknesses of the first to third preliminary metal patterns 210a, 210b, and 210c. The first to third metal patterns 212a, 212b, and 212c exposed by the etching mask pattern 214 may have a second thickness less than the first thickness. Each of the first to third metal patterns 212a, 212b, and 212c may include a portion having the first thickness and a portion having a second thickness less than the first thickness.

An upper surface of each of the first to third metal patterns 212a, 212b, and 212c may include a recess portion R. Accordingly, an upper surface of each of the first to third metal patterns 212a, 212b, and 212c may have different height depending on positions thereof. The upper surface of each of the first to third metal patterns 212a, 212b, and 212c may include a first portion a1 having a first height and a second portion a2 having a second height. As an example, the second height of the second portion a2 of the first metal pattern 212a may less than the first height of the first portion a1 of the first metal pattern 212a.

In example embodiments, the thickness of each of the first to third metal patterns 212a, 212b, and 212c may be locally thin by the recess portion R, so that a parasitic capacitance may be decreased and a resistance between wirings may be adjusted.

In some example embodiments, partially etching the upper portions of the first to third preliminary metal patterns 210a, 210b, and 210c may not be performed. In this case, the first to third preliminary metal patterns 210a, 210b, and 210c may be used as the first to third metal patterns, and an upper surface of each of the first to third metal patterns 212a, 212b, and 212c may have same height.

In some example embodiments, upper surfaces of at least one among the first to third metal patterns 212a, 212b, and 212c may not include the recess portion R.

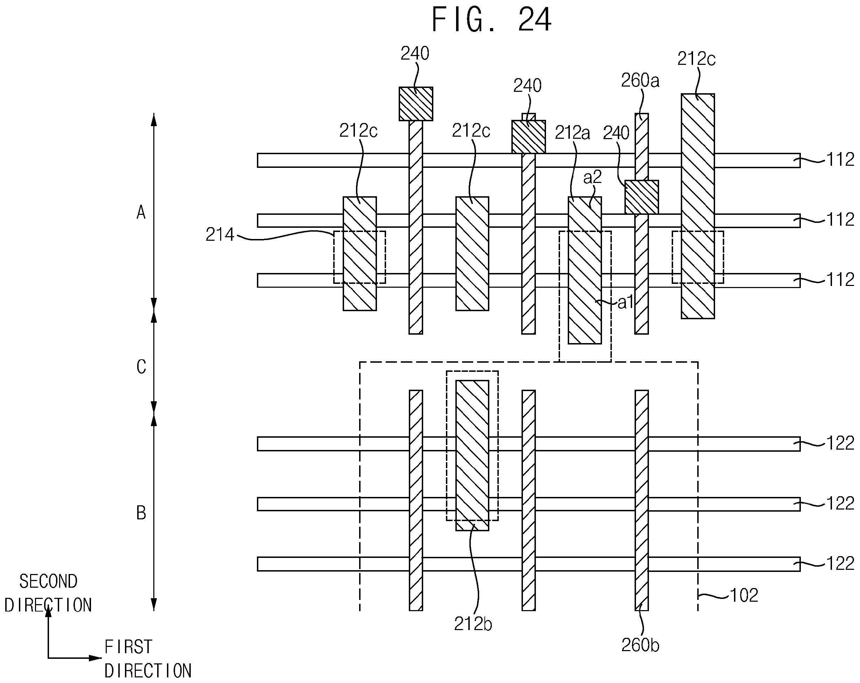

Referring to FIG 24, portions of the second insulating interlayer 172 and the first insulating interlayer 170 on the PMOS region A may be etched, and the second capping pattern of the first gate structure 160a may be etched to form a first contact hole exposing the first gate pattern 164a. In the etching process, the first contact hole may not be formed on the N-well tap forming region B.

A second metal layer may be formed on the second insulating interlayer 172 to fill the first contact hole. The second metal layer may include, e.g., tungsten. Thereafter, the second metal layer may be planarized until an upper surface of the second insulating interlayer 172 may be exposed to form a first contact plug 240. The first contact plug 240 may contact the first gate pattern 164a on the PMOS region A. Electrical signals may be applied to the first gate pattern 164a through the first contact plug 240.

However, the first contact plug 240 may not be formed on the second gate pattern 164b on the N-well tap forming region B. Electrical signals may not be applied to the second gate pattern. Therefore, the second gate pattern 164b may not operate as an actual gate electrode.

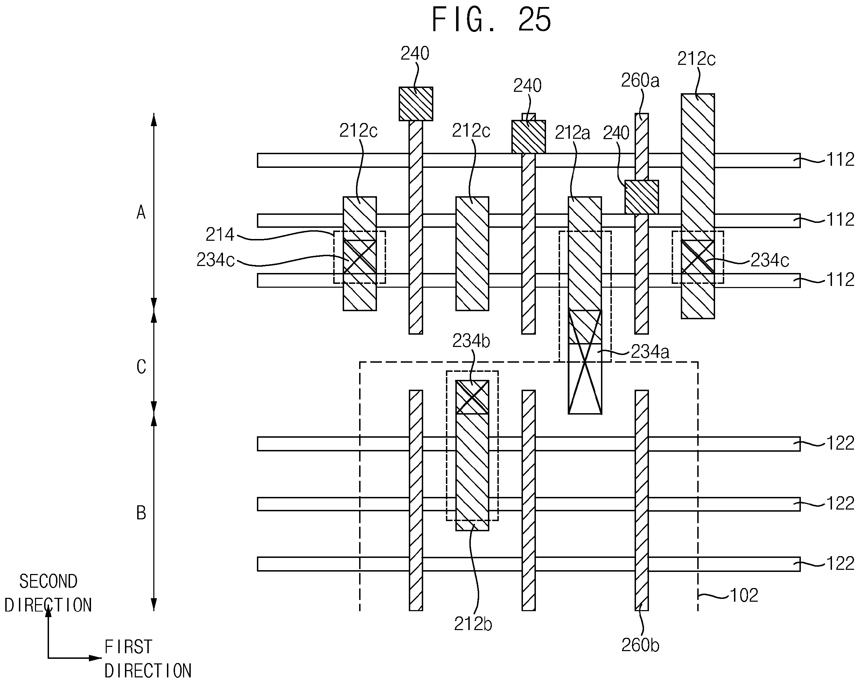

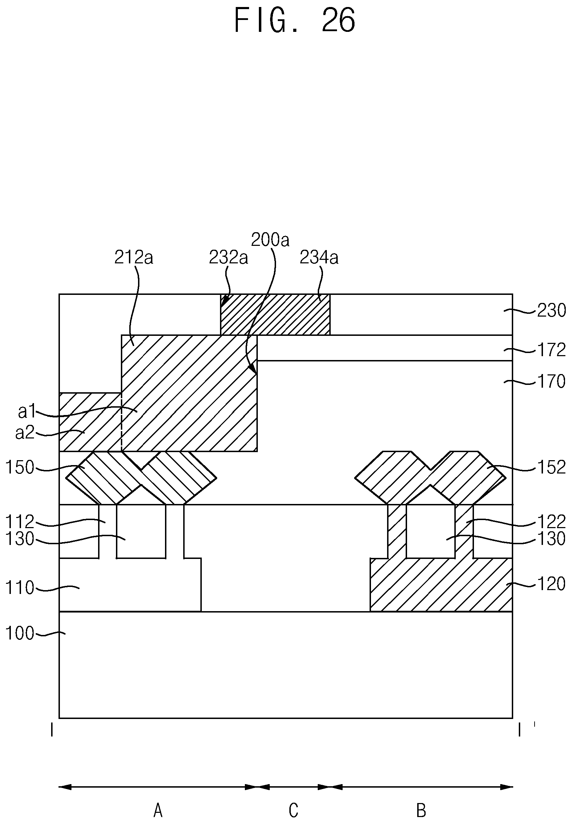

Referring to FIGS. 25 and 26, a third insulating interlayer 230 may be formed on the first to third metal patterns 212a, 212b, and 212c and the second insulating interlayer 172.

A portion of the third insulating interlayer 230 may be etched to form a second contact hole 232a exposing an upper surface of the first metal pattern 212a, a third contact hole exposing an upper surface of the second metal pattern 212b and a fourth contact hole exposing an upper surface of the third metal pattern 212c, respectively.

A third metal layer may be formed on the third insulating interlayer 230 to fill the second to fourth contact holes. The third metal layer may include, e.g., tungsten.

Thereafter, the third metal layer may be planarized until an upper surface of the third insulating interlayer 230 may be exposed to form a second contact plug 234a, a third contact plug 234b and a fourth contact plug 234c, respectively. The second contact plug 234a may be formed in the second contact hole 232a. The third contact plug 234b may be formed in the third contact hole. The fourth contact plug 234c may be formed in the fourth contact hole.

Each of the first to third metal patterns 212a, 212b, and 212c disposed under the second to fourth contact plugs 234a, 234b, and 234c may not directly connect between the first semiconductor structure 150 serving as the impurity region of the PMOS FET and the second semiconductor structure 152 connected to the N-well tap region 102. Therefore, the second to fourth contact plugs 234a, 234b, and 234c may not have a defect in which metal of upper portions of the second to fourth contact plugs 234a, 234b, and 234c is consumed or removed due to anodic corrosion. Accordingly, a top surface of each of the second to fourth contact plugs 234a, 234b, and 234c may have a target height.

In the above process, the semiconductor device shown in FIG 1 or 5 may be manufactured by controlling a position of the second contact hole 232a for forming the second contact plug 234a.

For example, the second contact plug 234a may be formed such that a width in the second direction of a third portion of the second contact plug 234a contacting the first metal pattern 212a may be equal to or less than a width in the second direction of a fourth portion of the second contact plug 234a contacting the second insulating interlayer 172.

In another example, as shown in FIG 6, the second contact plug 234a may be formed such that a width in the second direction of a third portion of the second contact plug 234a contacting the first metal pattern 212a may be greater than a width in the second direction of a fourth portion of the second contact plug 234a contacting the second insulating interlayer 172.

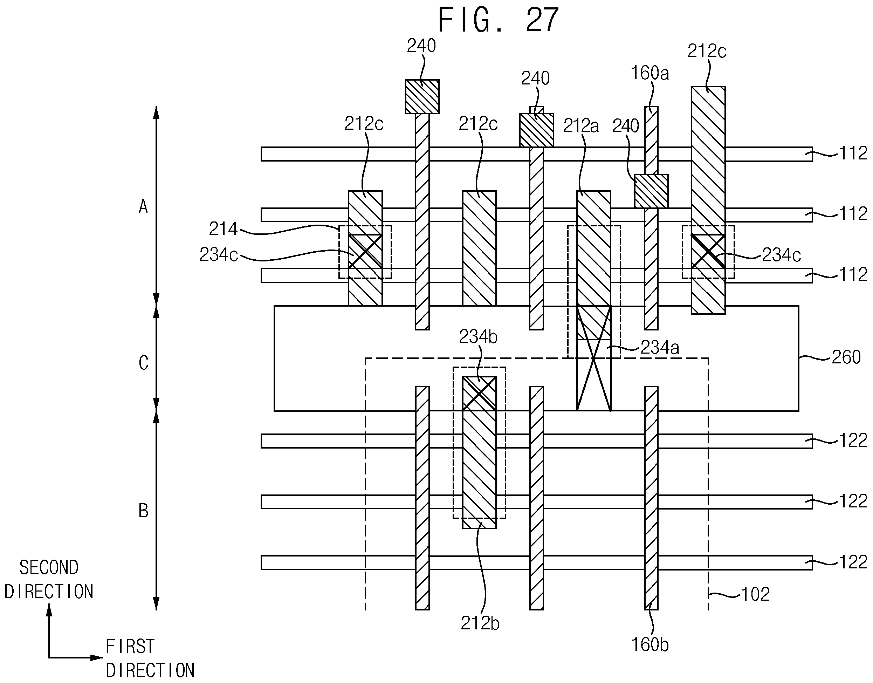

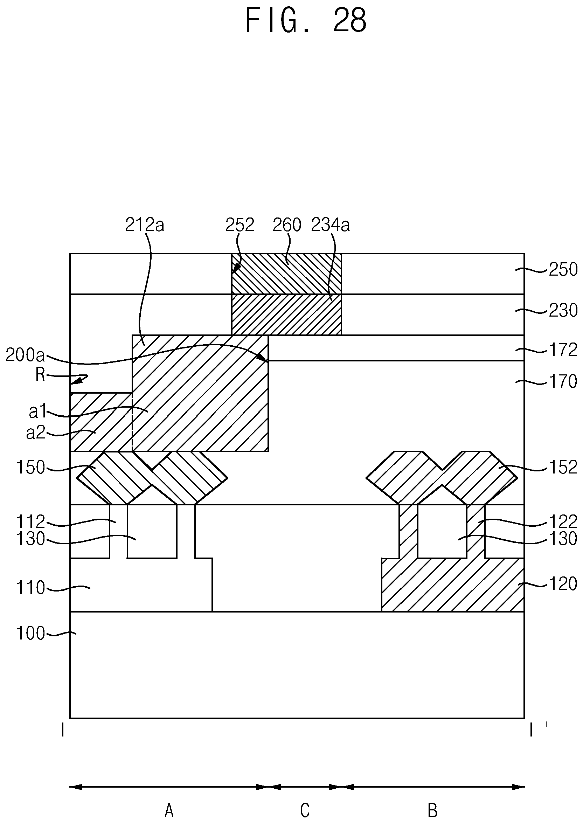

Referring to FIGS. 27 and 28, a fourth insulating interlayer 250 may be formed on the third insulating interlayer 230.

A portion of the fourth insulating interlayer 250 may be etched to form a fourth opening 252. The fourth opening 252 may extend in the first direction to expose upper surfaces of the second and third contact plugs 234a and 234b.

A fourth metal layer may be formed in the fourth opening 252. The fourth metal layer may include, e.g., copper.

Thereafter, the fourth metal layer may be planarized until an upper surface of the fourth insulating interlayer 250 may be exposed to form a first upper wiring line 260. The first upper wiring line 260 may be formed in the fourth opening 252.

In the above process, the semiconductor device shown in FIG 1 or 5 may be manufactured by controlling a position of the fourth opening 252 for forming the upper wiring line 260.

For example, as shown in FIG 1, in the cross-sectional view in the second direction, a width of the upper wiring line 260 in the second direction may be substantially the same as a width of the second contact plug 234a thereunder in the second direction. For example, as shown in FIG 5, in the cross-sectional view in the second direction, a width of the upper wiring line 260 in the second direction may be greater than a width of the second contact plug 234a thereunder in the second direction.

A first upper wiring electrically connected to the first contact plug and a second upper wiring electrically connected to the fourth contact plug may be further formed on the first contact plug and the fourth contact plug, respectively.

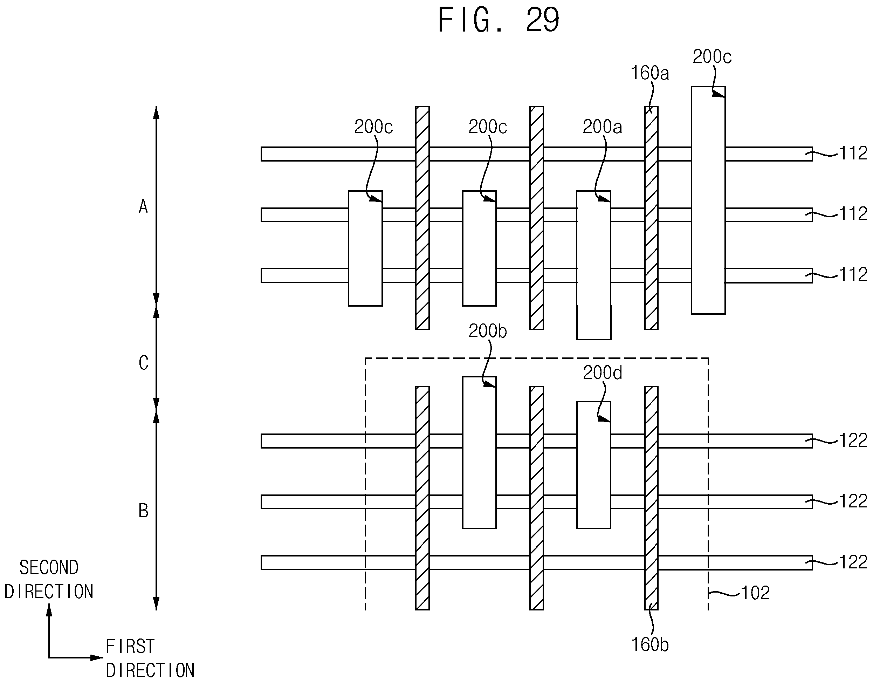

FIG 29 is a plan view illustrating a method of manufacturing a semiconductor device in accordance with example embodiments of the inventive concept.

The semiconductor device shown in FIGS. 7 and 8 may be manufactured by processes similar to processes described with reference to FIGS. 11 to 28.

First, the processes described with reference to FIGS. 11 to 17 may be performed in the same manner.

Referring to FIG 29, when the processes described with reference to FIGS. 18 and 19 are performed, a fourth opening 200d may be further formed in a region for forming a fourth metal pattern. The fourth opening 200d may be formed on the second semiconductor structure 152 facing the first opening in the second direction. The second semiconductor structure 152 on the n-well tap forming region B and the insulating interlayer on the boundary region C may be exposed by a bottom of the fourth opening 200d.

Thereafter, the semiconductor device shown in FIG 29 may be manufactured by performing substantially the same processes as those described with reference to FIGS. 20 to 28. However, when the processes described with reference to FIGS. 25 and 26 are performed, the second contact plug 234a may be formed such that a width in the second direction of a third portion of the second contact plug 234a contacting the first metal pattern 212a is greater than a width in the second direction of a fourth portion of the second contact plug 234a contacting the second insulating interlayer 172.

In addition, when the processes described with reference to FIGS. 27 and 28 are performed, in the cross-sectional view in the second direction, a width of the upper wiring line 260 in the second direction may be greater than a width of the second contact plug 234a thereunder in the second direction.

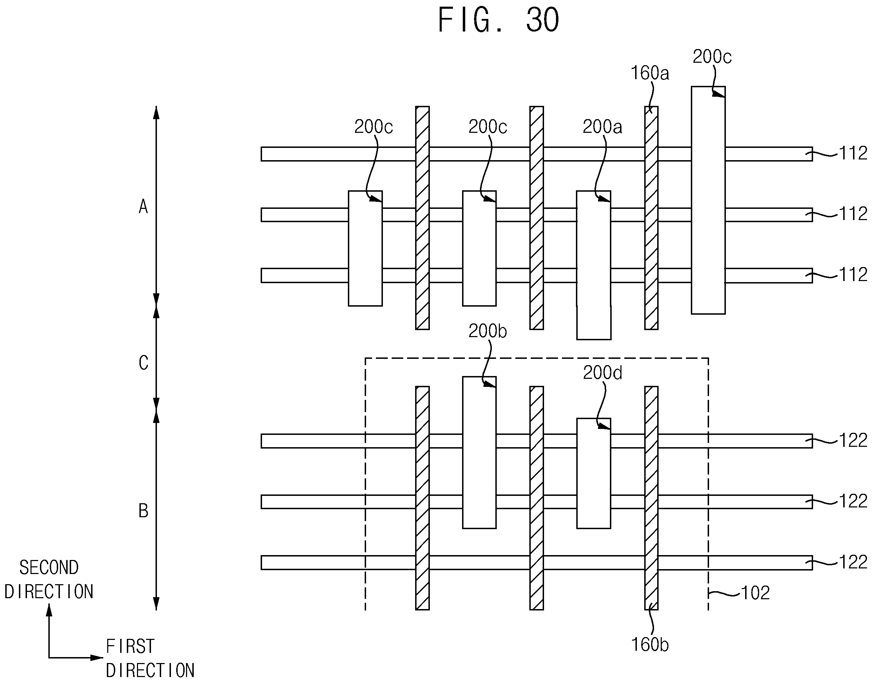

FIG 30 is a plan view illustrating a method of manufacturing a semiconductor device in accordance with example embodiments of the inventive concept.

The semiconductor device shown in FIGS. 9 and 10 may be manufactured by processes similar to processes described with reference to FIGS. 11 to 28.

First, the process described with reference to FIGS. 11 to 17 may be performed in the same manner.

Referring to FIG 30, when the processes described with reference to FIGS. 18 and 19 are performed, a fourth opening 200d may be further formed on a region for forming a fourth metal pattern. The fourth opening 200d may be formed on the second semiconductor structure 152 facing the first opening in the second direction. The second semiconductor structure 152 on the n-well tap forming region B may be exposed by a bottom of the fourth opening 200d, and the insulating interlayer on the boundary region C may not be exposed by the bottom of the fourth opening 200d.

Thereafter, the semiconductor device shown in FIG 30 may be manufactured by performing substantially the same processes as those described with reference to FIGS. 20 to 28. However, when the processes described with reference to FIGS. 25 and 26 are performed, the second contact plug 234a may be formed such that a width in the second direction of a portion of the second contact plug 234a contacting the first metal pattern 212a is equal to or smaller than a width in the second direction of a portion of the second contact plug 234a contacting the second insulating interlayer 172.

In addition, when the processes described with reference to FIGS. 27 and 28 are performed, in the cross-sectional view in the second direction, a width of the upper wiring line 260 in the second direction may be substantially the same as a width of the second contact plug 234a thereunder in the second direction.

As described above, connection defects in the semiconductor device may be decreased. Accordingly, the semiconductor device may have desired electrical characteristics.

The foregoing is illustrative of example embodiments of the inventive concept and is not to be construed as limiting thereof. Although a few example embodiments have been described, those skilled in the art will readily appreciate that many modifications are possible in the example embodiments without materially departing from the scope of the inventive concept. Accordingly, all such modifications are intended to be included within the scope of the inventive concept as set forth in the claims.

## Claims

1. A semiconductor device, comprising:
a substrate (100) including a p-channel metal-oxide-semiconductor, PMOS, region (A), an N-well tap forming region (B), and a boundary region (C) between the PMOS region and the N-well tap forming region;
PMOS field effect transistors on the PMOS region;
an N-well tap region doped with N-type impurities in the N-well tap forming region;
a first metal pattern (212a) connected to at least one impurity region of the PMOS field effect transistors, wherein the first metal pattern extends so that an end of the first metal pattern is positioned on the boundary region;
a second metal pattern (212b) electrically connected to the N-well tap region, wherein the second metal pattern extends so that an end of the second metal pattern is positioned on the boundary region;
a first contact plug (234a) on the first metal pattern;
a second contact plug (234b) on the second metal pattern; and
an upper wiring (260) on the first and second contact plugs.

2. The semiconductor device of claim 1, wherein a metal pattern is not disposed in an area of the N-well tap forming region that faces the first metal pattern (212a) in an extending direction of the first metal pattern.

3. The semiconductor device of claim 1 or 2, further comprising a third metal pattern (212c) disposed in an area of the N-well tap forming region (B) that faces the first metal pattern (212a) in an extending direction of the first metal pattern,
wherein the third metal pattern is electrically connected to the N-well tap region, and is spaced apart from the first metal pattern, and
wherein an end of the third metal pattern extends to the boundary region (C).

4. The semiconductor device of any preceding claim, wherein a bottom of the first contact plug (234a) includes a first portion contacting the first metal pattern (212a) and a second portion not contacting the first metal pattern.

5. The semiconductor device of any preceding claim, wherein the first metal pattern (212a) and the second metal pattern (212b) are not aligned along a line in an extending direction of the first metal pattern.

6. A semiconductor device, comprising:
a substrate including a p-channel metal-oxide-semiconductor (PMOS) region, an N-well tap forming region, and a boundary region between the PMOS region and the N-well tap forming region;
first active fins (112) extending in a first direction on the PMOS region;
a first gate structure (160a) on the first active fins, the first gate structure crossing the first active fins and extending in a second direction perpendicular to the first direction, wherein an end of the first gate structure is positioned on the boundary region;
first semiconductor structures (150) on the first active fins, each of the first semiconductor structures being doped with P-type impurities and connecting the first active fins to each other;
an N-well tap region doped with N-type impurities in the N-well tap forming region;
second active fins (122) extending in the first direction on the N-well tap forming region;
a second gate structure (160b) on the second active fins, the second gate structure crossing the second active fins and extending in the second direction, wherein an end of the second gate structure is positioned on the boundary region;
second semiconductor structures (152) on the second active fins, each of the second semiconductor structures being doped with N-type impurities and connecting the second active fins to each other;
a first metal pattern (212a) on an upper surface of at least one of the first semiconductor structures (150), wherein an end of the first metal pattern extends to the boundary region;
a second metal pattern (212b) on an upper surface of at least one of the second semiconductor structures, wherein an end of the second metal pattern extends to the boundary region;
a first contact plug (234b) on the first metal pattern;
a second contact plug (234b) on the second metal pattern; and
an upper wiring on the first and second contact plugs.

7. The semiconductor device of claim 6, wherein a metal pattern is not disposed in an area of the N-well tap forming region that faces the first metal pattern (212a) in the second direction.

8. The semiconductor device of claim 6 or 7, further comprising a third metal pattern (212c) in an area of the N-well tap forming region that faces the first metal pattern (212a) in the second direction,
wherein the third metal pattern is electrically connected to the N-well tap region, and is spaced apart from the first metal pattern, and
wherein an end of the third metal pattern extends to the boundary region.

9. The semiconductor device of claim 6, 7 or 8, wherein each of the first (212a) and second (212b) metal patterns extends in the second direction.

10. The semiconductor device of any one of claims 6 to 9, wherein the first (212a) and second (212b) metal patterns are not aligned in a line in the second direction.

11. The semiconductor device of any one of claims 6 to 10, wherein a bottom of the first contact plug (234b) includes a first portion contacting the first metal pattern (212a) and a second portion not contacting the first metal pattern.

12. The semiconductor device of any one of claims 6 to 11, wherein the first semiconductor structure (150) includes silicon germanium, and the second semiconductor structure (152) includes silicon.

13. The semiconductor device of any one of claims 6 to 12, wherein an upper surface of the first metal pattern (212a) includes a third portion having a first height and a fourth portion having a second height different from the first height.

14. The semiconductor device of any one of claims 6 to 13, further comprising a third contact plug (234b) on the first gate structure,
wherein the third contact plug is electrically connected to the first gate structure.

## Patentansprüche

1. Halbleitervorrichtung, die Folgendes umfasst:
ein Substrat (100) einschließlich einer p-Kanal-Metall-Oxid-Halbleiter(PMOS)-Region (A), einer N-Wannen-Abgriffbildungsregion (B) und einer Grenzregion (C) zwischen der PMOS-Region und der n-Wannen-Abgriffbildungsregion;
PMOS-Feldeffekttransistoren auf der PMOS-Region;
eine N-Wannen-Abgriffregion, die mit N-Typ-Verunreinigungen in der N-Wannen -Abgriffbildungsregion dotiert ist;
ein erstes Metallmuster (212a), das mit mindestens einer Verunreinigungsregion der PMOS-Feldeffekttransistoren verbunden ist, wobei sich das erste Metallmuster so erstreckt, dass ein Ende des ersten Metallmusters in der Grenzregion positioniert ist;
ein zweites Metallmuster (212b), das elektrisch mit der N-Wannen-Abgriffregion verbunden ist, wobei sich das zweite Metallmuster so erstreckt, dass ein Ende des zweiten Metallmusters in der Grenzregion positioniert ist;
einen ersten Kontaktstecker (234a) auf dem ersten Metallmuster;
einen zweiten Kontaktstecker (234b) auf dem zweiten Metallmuster; und
eine obere Verdrahtung (260) auf dem ersten und dem zweiten Kontaktstecker.

2. Halbleitervorrichtung nach Anspruch 1, wobei kein Metallmuster in einem Bereich der N-Wannen-Abgriffbildungsregion angeordnet ist, der dem ersten Metallmuster (212a) in einer Erstreckungsrichtung des ersten Metallmusters zugewandt ist.

3. Halbleitervorrichtung nach Anspruch 1 oder 2, die ferner ein drittes Metallmuster (212c) umfasst, das in einem Bereich der N-Wannen-Abgriffbildungsregion (B) angeordnet ist, der dem ersten Metallmuster (212a) in einer Erstreckungsrichtung des ersten Metallmusters zugewandt ist,
wobei das dritte Metallmuster elektrisch mit der N-Wannen-Abgriffregion verbunden ist, und von dem ersten Metallmuster beabstandet ist, und
wobei sich ein Ende des dritten Metallmusters zur Grenzregion (C) erstreckt.

4. Halbleitervorrichtung nach einem vorhergehenden Anspruch, wobei eine Unterseite des ersten Kontaktsteckers (234a) einen das erste Metallmuster (212a) kontaktierenden ersten Abschnitt und einen das erste Metallmuster nicht kontaktierenden zweiten Abschnitt einschließt.

5. Halbleitervorrichtung nach einem vorhergehenden Anspruch, wobei das erste Metallmuster (212a) und das zweite Metallmuster (212b) nicht entlang einer Linie in einer Erstreckungsrichtung des ersten Metallmusters ausgerichtet sind.

6. Halbleitervorrichtung, die Folgendes umfasst:
ein Substrat einschließlich einer p-Kanal-Metall-Oxid-Halbleiter(PMOS)-Region, einer N-Wannen-Abgriffbildungsregion und einer Grenzregion zwischen der PMOS-Region und der N-Wannen-Abgriffbildungsregion;
erste aktive Rippen (112), die sich in einer ersten Richtung in der PMOS-Region erstrecken;
eine erste Gate-Struktur (160a) auf den ersten aktiven Rippen, wobei die erste Gate-Struktur die ersten aktiven Rippen kreuzt und sich in einer zweiten Richtung senkrecht zur ersten Richtung erstreckt, wobei ein Ende der ersten Gate-Struktur in der Grenzregion positioniert ist;
erste Halbleiterstrukturen (150) auf den ersten aktiven Rippen, wobei jede der ersten Halbleiterstrukturen mit P-Typ-Verunreinigungen dotiert ist und die ersten aktiven Rippen miteinander verbindet;
eine N-Wannen-Abgriffregion, die mit N-Typ-Verunreinigungen in der N-Wannen-Abgriffbildungsregion dotiert ist;
zweite aktive Rippen (122), die sich in der ersten Richtung in der N-Wannen-Abgriffbildungsregion erstrecken;
eine zweite Gate-Struktur (160b) auf den zweiten aktiven Rippen, wobei die zweite Gate-Struktur die zweiten aktiven Rippen kreuzt und sich in der zweiten Richtung erstreckt, wobei ein Ende der zweiten Gate-Struktur in der Grenzregion positioniert ist;
zweite Halbleiterstrukturen (152) auf den zweiten aktiven Rippen, wobei jede der zweiten Halbleiterstrukturen mit N-Typ-Verunreinigungen dotiert ist und die zweiten aktiven Rippen miteinander verbindet;
ein erstes Metallmuster (212a) auf einer Oberseite von mindestens einer der ersten Halbleiterstrukturen (150), wobei sich ein Ende des ersten Metallmusters zur Grenzregion erstreckt;
ein zweites Metallmuster (212b) auf einer Oberseite von mindestens einer der zweiten Halbleiterstrukturen, wobei sich ein Ende des zweiten Metallmusters zur Grenzregion erstreckt;
einen ersten Kontaktstecker (234b) auf dem ersten Metallmuster;
einen zweiten Kontaktstecker (234b) auf dem zweiten Metallmuster; und
eine obere Verdrahtung auf dem ersten und dem zweiten Kontaktstecker.

7. Halbleitervorrichtung nach Anspruch 6, wobei ein Metallmuster nicht in einem Bereich der N-Wannen-Abgriffbildungsregion angeordnet ist, der dem ersten Metallmuster (212a) in der zweiten Richtung zugewandt ist.

8. Halbleitervorrichtung nach Anspruch 6 oder 7, die ferner ein drittes Metallmuster (212c) in einem Bereich der N-Wannen-Abgriffbildungsregion umfasst, der dem ersten Metallmuster (212a) in der zweiten Richtung zugewandt ist,
wobei das dritte Metallmuster elektrisch mit der N-Wannen-Abgriffregion verbunden ist, und vom ersten Metallmuster beabstandet ist, und
wobei sich ein Ende des dritten Metallmusters zur Grenzregion erstreckt.

9. Halbleitervorrichtung nach Anspruch 6, 7 oder 8, wobei sich das erste (212a) und das zweite (212b) Metallmuster jeweils in der zweiten Richtung erstrecken.

10. Halbleitervorrichtung nach einem der Ansprüche 6 bis 9, wobei das erste (212a) und das zweite (212b) Metallmuster in der zweiten Richtung nicht in einer Linie ausgerichtet sind.

11. Halbleitervorrichtung nach einem der Ansprüche 6 bis 10, wobei eine Unterseite des ersten Kontaktsteckers (234b) einen das erste Metallmuster (212a) kontaktierenden ersten Abschnitt und einen das erste Metallmuster nicht kontaktierenden zweiten Abschnitt umfasst.

12. Halbleitervorrichtung nach einem der Ansprüche 6 bis 11, wobei die erste Halbleiterstruktur (150) Siliziumgermanium einschließt, und die zweite Halbleiterstruktur (152) Silizium einschließt.

13. Halbleitervorrichtung nach einem der Ansprüche 6 bis 12, wobei eine Oberseite des ersten Metallmusters (212a) einen dritten Abschnitt mit einer ersten Höhe und einen vierten Abschnitt mit einer sich von der ersten Höhe unterscheidenden zweiten Höhe einschließt.

14. Halbleitervorrichtung nach einem der Ansprüche 6 bis 13, die ferner einen dritten Kontaktstecker (234b) auf der ersten Gate-Struktur umfasst,
wobei der dritte Kontaktstecker elektrisch mit der ersten Gate-Struktur verbunden ist.

## Revendications

1. Dispositif semi-conducteur, comprenant :
un substrat (100) incluant une région métal-oxyde-semi-conducteur à canal p, PMOS (A), une région formant prise de puits N (B), et une région limite (C) entre la région PMOS et la région formant prise de puits N ;
des transistors à effet de champ PMOS sur la région PMOS ;
une région de prise de puits N dopée avec des impuretés de type N dans la région formant prise de puits N ;
un premier motif métallique (212a) connecté à au moins une région d'impureté des transistors à effet de champ PMOS, dans lequel le premier motif métallique s'étend de sorte qu'une extrémité du premier motif métallique est positionnée sur la région limite ;
un second motif métallique (212b) électriquement connecté à la région de prise de puits N, dans lequel le second motif métallique s'étend de sorte qu'une extrémité du second motif métallique est positionnée sur la région limite ;
une première fiche de contact (234a) sur le premier motif métallique ;
une seconde fiche de contact (234b) sur le second motif métallique ; et
un câblage supérieur (260) sur la première et la seconde fiche de contact.

2. Dispositif semi-conducteur selon la revendication 1, dans lequel un motif métallique n'est pas disposé dans une zone de la région formant prise de puits N qui fait face au premier motif métallique (212a) dans un sens d'extension du premier motif métallique.

3. Dispositif semi-conducteur selon la revendication 1 ou 2, comprenant en outre un troisième motif métallique (212c) disposé dans une zone de la région formant prise de puits N (B) qui fait face au premier motif métallique (212a) dans un sens d'extension du premier motif métallique,
dans lequel le troisième motif métallique est électriquement connecté à la région de prise de puits N, et est espacé à l'écart du premier motif métallique, et
dans lequel une extrémité du troisième motif métallique s'étend vers la région limite (C).

4. Dispositif semi-conducteur selon l'une quelconque des revendications précédentes, dans lequel un fond de la première fiche de contact (234a) inclut une première portion entrant en contact avec le premier motif métallique (212a) et une seconde portion n'entrant pas en contact avec le premier motif métallique.

5. Dispositif semi-conducteur selon l'une quelconque des revendications précédentes, dans lequel le premier motif métallique (212a) et le second motif métallique (212b) ne sont pas alignés le long d'une ligne dans un sens d'extension du premier motif métallique.

6. Dispositif semi-conducteur, comprenant :
un substrat incluant une région métal-oxyde-semi-conducteur à canal p (PMOS), une région formant prise de puits N, et une région limite entre la région PMOS et la région formant prise de puits N ;
des premières ailettes actives (112) s'étendant dans un premier sens sur la région PMOS ;
une première structure de grille (160a) sur les premières ailettes actives, la première structure de grille traversant les premières ailettes actives et s'étendant dans un second sens perpendiculaire au premier sens, dans lequel une extrémité de la première structure de grille est positionnée sur la région limite ;
des premières structures semi-conductrices (150) sur les premières ailettes actives, chacune des premières structures semi-conductrices étant dopée avec des impuretés de type P et connectant les premières ailettes actives l'une à l'autre ;
une région de prise de puits N dopée avec des impuretés de type N dans la région formant prise de puits N ;
des secondes ailettes actives (122) s'étendant dans le premier sens sur la région formant prise de puits N ;
une seconde structure de grille (160b) sur les secondes ailettes actives, la seconde structure de grille traversant les secondes ailettes actives et s'étendant dans le second sens, dans lequel une extrémité de la seconde structure de grille est positionnée sur la région limite ;
des secondes structures semi-conductrices (152) sur les secondes ailettes actives, chacune des secondes structures semi-conductrices étant dopée avec des impuretés de type N et connectant les secondes ailettes actives l'une à l'autre ;
un premier motif métallique (212a) sur une surface supérieure d'au moins l'une des premières structures semi-conductrices (150), dans lequel une extrémité du premier motif métallique s'étend vers la région limite ;
un second motif métallique (212b) sur une surface supérieure d'au moins l'une des secondes structures semi-conductrices, dans lequel une extrémité du second motif métallique s'étend vers la région limite ;
une première fiche de contact (234b) sur le premier motif métallique ;
une seconde fiche de contact (234b) sur le second motif métallique ; et
un câblage supérieur sur la première et la seconde fiche de contact.

7. Dispositif semi-conducteur selon la revendication 6, dans lequel un motif métallique n'est pas disposé dans une zone de la région formant prise de puits N qui fait face au premier motif métallique (212a) dans le second sens.

8. Dispositif semi-conducteur selon la revendication 6 ou 7, comprenant en outre un troisième motif métallique (212c) dans une zone de la région formant prise de puits N qui fait face au premier motif métallique (212a) dans le second sens,
dans lequel le troisième motif métallique est électriquement connecté à la région de prise de puits N, et est espacé à l'écart du premier motif métallique, et
dans lequel une extrémité du troisième motif métallique s'étend vers la région limite.

9. Dispositif semi-conducteur selon la revendication 6, 7 ou 8, dans lequel chacun du premier (212a) et du second (212b) motif métallique s'étend dans le second sens.

10. Dispositif semi-conducteur selon l'une quelconque des revendications 6 à 9, dans lequel les premier (212a) et second (212b) motifs métalliques ne sont pas alignés dans une ligne dans le second sens.

11. Dispositif semi-conducteur selon l'une quelconque des revendications 6 à 10, dans lequel un fond de la première fiche de contact (234b) inclut une première portion entrant en contact avec le premier motif métallique (212a) et une seconde portion n'entrant pas en contact avec le premier motif métallique.

12. Dispositif semi-conducteur selon l'une quelconque des revendications 6 à 11, dans lequel la première structure semi-conductrice (150) inclut du silicium-germanium, et la seconde structure semi-conductrice (152) inclut du silicium.

13. Dispositif semi-conducteur selon l'une quelconque des revendications 6 à 12, dans lequel une surface supérieure du premier motif métallique (212a) inclut une troisième portion ayant une première hauteur et une quatrième portion ayant une seconde hauteur différente de la première hauteur.

14. Dispositif semi-conducteur selon l'une quelconque des revendications 6 à 13, comprenant en outre une troisième fiche de contact (234b) sur la première structure de grille,
dans lequel la troisième fiche de contact est électriquement connectée à la première structure de grille.
